# EUROPÄISCHE PATENTSCHRIFT

(11) **EP 1 825 504 B1**
(45) Veröffentlichungstag und Bekanntmachung des Hinweises auf die Patenterteilung: **28.03.2012**
(21) Anmeldenummer: 05825275.0
(22) Anmeldetag: 12.12.2005
(51) Int. Cl.: H01L 21/331, H01L 29/732, H01L 29/737

(54) **VERTIKALER BIPOLARTRANSISTOR**
VERTICAL BIPOLAR TRANSISTOR
TRANSISTOR BIPOLAIRE VERTICAL

(30) Priorität: 11.12.2004 DE 102004061327
(43) Veröffentlichungstag der Anmeldung: 29.08.2007
(73) Patentinhaber: IHP GmbH-Innovations for High Performance Microelectronics / Leibniz-Institut für innovative Mikroelektronik, 15236 Frankfurt / Oder (DE)
(72) Erfinder: MARSCHMAYER, Steffen, 15234 Frankfurt (DE); DREWS, Jürgen, 15230 Frankfurt (Oder) (DE); RÜCKER, Holger, 15526 Bad Saarow (DE); HEINEMANN, Bernd, 15234 Frankfurt (Oder) (DE)
(74) Vertreter: Eisenführ, Speiser & Partner
(86) Internationale Anmeldenummer: PCT/EP2005/056691
(87) Internationale Veröffentlichungsnummer: WO 2006/061439

(56) Entgegenhaltungen:
- EP-A- 0 669 647
- DE-A1- 3 901 881
- US-A- 5 166 767
- US-B1- 6 642 553

## Beschreibung

Die Erfindung betrifft eine Bipolar-Halbleitervorrichtung, insbesondere einen Vertikalen Heterobipolartransistor (HBT). Weiterhin betrifft die Erfindung ein Verfahren zur Herstellung einer solchen Bipolar-Halbleitervorrichtung.

Die Leistungsfähigkeit von Bipolartransistoren (engl.: Bipolar Junction Transistor, BJT) auf Siliziumbasis ist im Hochgeschwindigkeitsbereich durch neuartige Bauelementekonstruktionen und Materialkomponenten sowie durch Strukturverkleinerung wesentlich verbessert worden.

Wesentliche Merkmale moderner vertikaler Hochgeschwindigkeits-Bipolartransistoren sind in K. Washio, "SiGe HBT and BiCMOS Technologies", IEDM, S. 113-116, 2003 beschrieben.

Bekannte Ausführungen enthalten hoch leitfähige Basis- und Kollektoranschlussgebiete, die den Ladungsträgerstrom vom inneren Transistorgebiet zu den entsprechenden Kontaktgebieten hin abführen. Um gleichzeitig eine geringe Kapazität des Basisanschlussgebietes zu den übrigen elektrischen Anschlüssen des Transistors zu gewährleisten, werden die Halbleitergebiete durch Isolatorgebiete mit geringer Dielektrizitätskonstante, z. B. durch Siliziumdioxid, voneinander getrennt. Als Herstellungsverfahren für dieses Konstruktionsmerkmal haben sich die sogenannte Doppel-Polysilizium-Technologie bzw. die Single-Polysilizium-Technologie mit differentieller Basis-Epitaxie etabliert.

Der dabei erreichte Stand der Technik erfordert jedoch für beide Varianten einen Kompromiss zwischen geringsten Zuleitungswiderständen auf der einen Seite und geringsten Kapazitäten bzw. guten Werten der funktionale Transistorausbeute auf der anderen Seite.

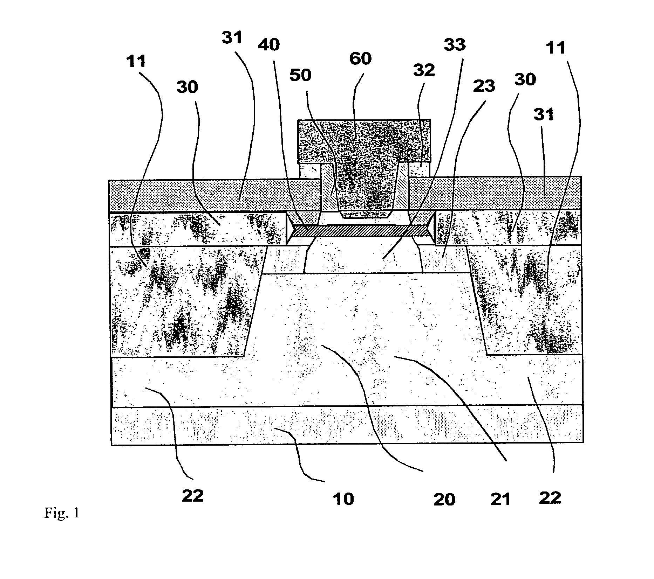

Dieser Zusammenhang wird für die Doppel-Polysilizium-Technologie anhand Fig. 1 verdeutlicht. Fig. 1 zeigt in einer Querschnittsansicht einen Bipolartransistor nach dem Stand der Technik, der in seinen wesentlichen Merkmalen dem Transistor der Fig. 1(a) aus der genannten Veröffentlichung von Washio entspricht. Ein Kollektorgebiet 20 grenzt nach unten an ein Substrat 10 und seitlich (lateral) an mit Siliziumdioxid (SiO₂) ausgefüllte Vertiefungen 11 im Silizium, die auch Feldisolationsgebiete genannt werden. Dabei kommen in verschiedenen Ausführungsformen nach dem Stand der Technik entweder flache Feldisolationsgebiete in Form flacher Gräben (eng!. Shallow Trench Isolation, STI), wie in Fig. 1 gezeigt, oder alternativ tiefere Gräben, so genannte Deep Trenches, zum Einsatz.

In vertikaler Richtung setzt sich das Kollektorgebiet 20 aus einem substratseitig gelegenen, hoch dotierten Kollektorbereich 21 und einem darüber liegenden, niedrig dotierten Kollektorbereich 23 zusammen. An das Kollektorgebiet schließen sich in lateraler Richtung unter den STI-Gebieten 11 Abschnitte 22 eines Kollektoranschlussgebietes an.

Über dem Kollektorgebiet 20 ist in einem Schichtstapel, der aus einer ersten Isolatorschicht 30, einer Polysiliziumschicht 31 und einer zweiten Isolatorschicht 32 besteht, ein Fenster 34 erzeugt. Durch selektive Ätzung der ersten Isolatorschicht 30 wird am seitlichen Rand des Fensters 34 ein über das erste Isolatorgebiet 30 seitlich hinausragender Abschnitt der Polysiliziumschicht 31 hergestellt. Die Stirnseiten der überhängenden Abschnitte der Polysiliziumschicht 31 sind mit Abstandshaltern, sogenannten Spacern 50 aus Isolatormaterial versehen.

Während eines selektiven Epitaxie-Schrittes zur Herstellung einer Basisschicht 40 wachsen zugleich Siliziumfronten von den freiliegenden Abschnitten der Polysiliziumschicht 31 und dem Kollektorgebiet 20 in vertikaler Richtung aufeinander zu und verschließen die Lücke zwischen der als Teil des Basisanschlussgebietes dienenden Polysiliziumschicht 31 und dem inneren Transistorgebiet.

Ein T-förmiges Emittergebiet 60 grenzt mit einem vertikalen Abschnitt, der dem vertikalen T-Balken entspricht, unten an die Basisschicht 40 und seitlich an die Spacer 50 an. Über der SiGe-Schicht ist eine Cap-Schicht abgeschieden, die im Herstellungsprozess eindiffundierende Dotanden aus dem Emitter aufnehmen kann und wenigstens einen Teil der Basis-Emitter-Raumladungszone aufnehmen kann. Die emitterseitige Grenze der Cap-Schicht ist durch eine Trennlinie im Emitter angedeutet. Dem horizontalen T-Balken entsprechende Abschnitte des Emitters 60 liegen seitwärts auf der zweiten Isolatorschicht 32 auf.

Ein weiteres typisches Merkmal dieser bekannten Transistorkonstruktion ist ein selektiv implantierter Kollektor- (SIC) Bereich 33 (englisch: selectively implanted collector, SIC), in welchem die Kollektordotierung lokal angehoben ist, um gleichzeitig die Kollektor-Basis-Transitzeit, die Basis-Kollektorkapazität und den Kollektorwiderstand in einer Weise zu minimieren, die gute Hochgeschwindigkeitseigenschaften des Transistors ermöglicht.

Betrachtet man die in Fig. 1 gezeigte Kollektoranordnung, existieren im Kollektorgebiet seitlich vom SIC-Bereich 33 schwächer dotierte Siliziumgebiete 23, die wegen ihres erhöhten elektrischen Widerstandes keinen merklichen Beitrag zum Transport des Kollektorstromes liefern, aber mindestens in einem Teil der überhängenden Abschnitte der Polysiliziumschicht 31 parasitäre Beiträge zur Basis-Kollektor-Kapazität verursachen.

Ohne Nachteile für andere Transistoreigenschaften könnte dieser parasitäre Kapazitätsanteil verkleinert werden, wenn es gelänge, das seitlich an den SIC-Bereich grenzende, niedrig dotierte Siliziumgebiet durch SiO₂ zu ersetzen.

Denkbar wäre die Herstellung dieses Vorrichtungsmerkmales über eine Verringerung der Weite des inneren Kollektorgebietes, und zwar in der Art, dass sich die Öffnung der ersten Isolatorschicht 30 teilweise auch über die STI-Gebiete 11 erstreckt, indem die seitliche Begrenzung der ersten Isolatorschicht 30 über das Kollektorgebiet hinausragt.

Unter Verwendung der typischen Herstellungsprozesse für diese Transistorkonstruktion würde dieses Vorgehen jedoch zu nicht tolerierbar schädlichen Folgen für den Basiswiderstand führen, weil wegen des selektiven Wachstumsverhaltens während des Epitaxieschrittes nicht mehr die volle Breite der Lücke unter dem überhängenden Abschnitt der Polysiliziumschicht 31 mit Silizium gefüllt würde. Des weiteren besteht auch ein wesentlich erhöhtes Risiko dafür, dass Kristalldefekte in die aktive Transistorregion hineinragen und damit die funktionale Transistorausbeute beeinträchtigt wird.

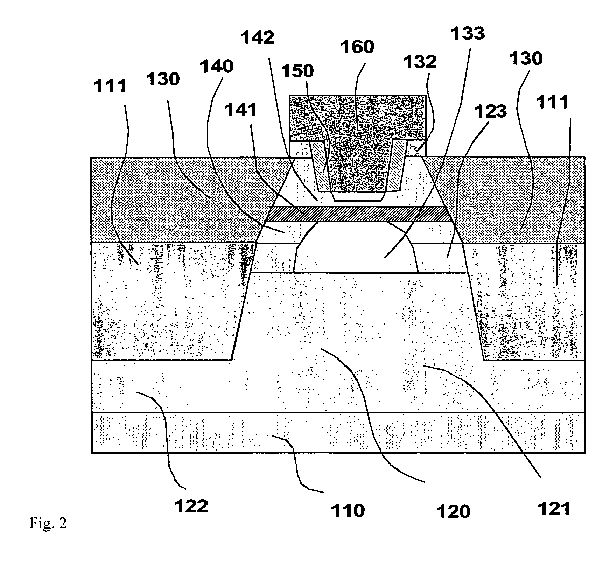

Fig. 2 zeigt in einer Querschnittsansicht einen weiteren vertikalen Bipolartransistor nach dem Stand der Technik. Schematisch dargestellt ist ein Ausschnitt des inneren Transistorgebiets sowie der angrenzendem Basis- und Kollektoranschlussgebiete. Der Transistor der Fig. 2 weist eine Einfach-Polysilizium-Konstruktion mit differentiell abgeschiedener Basis auf. Wesentliche Merkmale der Kollektorkonstruktion stimmen mit denjenigen der Doppel-Polysilizium-Variante von Fig. 1 überein.

Ein Kollektor 120 wird nach unten hin von einem Substrat 110 und zu den Seiten hin von STI-Gebieten 111 eingeschlossen. Substratseitig hat der Kollektor 120 einen hochdotierten Abschnitt 121. Zur Oberfläche hin hat der Kollektor einen niedrig dotierten Abschnitt 123. Im Unterschied zur Doppel-Polysilizium-Konstruktion der Fig. 1, bei der die Abscheidung der Polysiliziumschicht 31 unabhängig von der der Basisschicht erfolgt, wird in der Einfach-Polysilizium-Variante während des differentiellen Epitaxieschrittes für die Basisherstellung auf den Feldisolationsgebieten polykristallines Halbleitermaterial 130 deponiert, welches als Teil des Basisanschlussgebietes benutzt werden kann.

Für die Fertigung der in Fig. 2 gezeigten Emitterkonstruktion 160 lassen sich die in der noch nicht veröffentlichten Patentanmeldung DE10358046.8 der vorliegenden Anmelderin beschriebenen Verfahren einsetzen.

Aus den weiter oben beschriebenen Gründen wird ebenso wie in der Doppel-Polysilizium-Variante ein SIC-Gebiet 133 verwendet. Auch die bekannten Einfach-Polysilizium-Transistorkonstruktionen zeigen typischerweise schwächer dotierte Siliziumgebiete in seitlicher Nachbarschaft zum SIC-Gebiet 133, die unerwünschte Kapazitätsbeiträge zwischen Basisanschluss- und Kollektorgebiet hervorrufen.

Allerdings würde die oben beschriebene Vorgehensweise zur Verringerung dieser parasitären Kapazität, bei der nämlich die laterale Ausdehnung des Kollektorgebietes bei festgehaltener Breite des Emitterfensters verkleinert würde, bei der Einfach-Polysilizium-Technologie nicht zwangsläufig eine Vergrößerung des Basiswiderstandes bewirken. Mit einer Verschiebung der STI-Gebiete 111 würde jedoch gleichzeitig die Grenze zwischen einem einkristallin auf dem Kollektorgebiet 120 aufgewachsenen Schichtstapel, bestehend aus Pufferschicht 140, Basisschicht 141 und Deckelschicht 142, und dem polykristallin auf dem STI-Gebiet abgeschiedenen Silizium in Richtung Emitter 160 verschoben. Damit würde sich auch die Front des aus dem Polysilizium 130 ausdiffundierenden Dotierstoffes in Richtung SIC-Gebiet 133 verschieben. Durch diese Vorgehensweise verkleinerte sich zwar die Fläche des horizontal verlaufenden Teils der Raumladungszone zwischen der Basisschicht 141 und dem Kollektorgebiet und folglich der dazugehörige Kapazitätsbeitrag. Optimierte Anordnungen nach dem Stand der Technik werden aus diesem Vorgehen jedoch keinen Nutzen ziehen, weil einerseits die Gesamtkapazität durch die Zunahme anderer Komponenten der Basis-Kollektor-Kapazität wachsen oder weil andererseits die Gefahr für Kristalldefekte im inneren Transistorgebiet unzulässig ansteigen könnte. Der zuletzt genannte Nachteil ist insbesondere durch die Wachstumsrichtung der Kristallstörungen am Übergang vom einkristallinen zum polykristallinen Halbleitermaterial während der differentiellen Epitaxie sowie durch die indirekte Justage des Emitters zum Kollektorgebiet begründet.

Zysammenfassend wird zu der bisher geübten Kritik am Stand der Technik folgender erster Aspekt hervorgehoben: Sowohl in der Einfach- als auch in der Doppel-Polysilizium-Technologie gibt es konstruktionsbedingt keine nahe liegende Möglichkeit, die Basis-Kollektor-Kapazität durch Variation der Kollektorbreite weiter zu minimieren, ohne dass andere, für bestes Hochgeschwindigkeitsverhalten notwendige Eigenschaften erheblich beeinträchtigt werden.

Die in den Fig. 1 und 2 dargestellten bekannten Transistoranordnungen zeigen überdies einen zweiten kritikwürdigen Aspekt: Die auf Isolatorgebiet liegenden Teile des Basisanschlusses bestehen aus polykristallinem Material, wodurch Kontakt- und Zuleitungswiderstände im Vergleich zu Werten für einkristallines Material spürbar vergrößert sind.

Das der Erfindung zugrunde liegende technische Problem ist es daher, einen vertikalen Heterobipolartransistor anzugeben, bei dem verbesserte Eigenschaften für Hochgeschwindigkeitsanwendungen erzielt werden.

Ein weiteres, der Erfindung zugrunde liegendes technisches Problem ist es, ein Verfahren zur Herstellung eines Heterobipolartransistors anzugeben, mit dem die beschriebenen Nachteile bekannter Verfahren insbesondere im Hinblick auf parasitäre Kapazitäten und Widerstände vermieden werden können.

Diese Aufgaben werden gelöst durch einen vertikalen Bipolartransistor gemäß Anspruch 1, mit einem Substrat aus Halbleitermaterial eines ersten Leitfähigkeitstyps und einem darin ausgebildeten Isolationsgebiet,
- einer in einer Öffnung des Isolationsgebietes angeordneten ersten Halbleiterelektrode aus einkristallinem Halbleitermaterial eines zweiten Leitfähigkeitstyps, die entweder als Kollektor oder als Emitter ausgebildet ist, und die einen ersten Höhenabschnitt aufweist, der vom Isolationsgebiet in zu einer Höhenrichtung senkrecht stehenden lateralen Richtungen umschlossen ist und einen angrenzenden, in der Höhenrichtung vom Substratinneren weiter entfernten zweiten Höhenabschnitt aufweist, der lateral nicht vom Isolationsgebiet umschlossen ist,
- einer zweiten Halbleiterelektrode aus Halbleitermaterial des zweiten Leitfähigkeitstyps, die als der andere Typ Halbleiterelektrode, also als Emitter beziehungsweise alternativ als Kollektor ausgebildet ist,
- einer Basis aus einkristallinem Halbleitermaterial des ersten Leitfähigkeitstyps zwischen dem Kollektor und dem Emitter, und
- einem Basisanschlussgebiet, das einen einkristallinen Abschnitt aufweist, der in lateraler Richtung die Basis und den, von der Basis aus gesehen weiter zum Substratinneren liegenden, zweiten Höhenabschnitt der ersten Halbleiterelektrode lateral umgibt, und der mit seiner zum Substratinneren weisenden Unterseite unmittelbar auf dem Isolationsgebiet aufliegt, und der nachfolgend als vertikal isolierter einkristalliner Basisanschlussgebietsabschnitt, kurz VIEBAG-Abschnitt bezeichnet wird,
wobei die Lateralerstreckung eines Höhenabschnitts des VIEBAG-Abschnitts, welcher den zweiten Höhenabschnitt der ersten Halbleiterelektrode lateral umgibt, größer ist als der in Höhenrichtung gemessene Abstand zwischen einer Oberkante des Isolationsgebietes und einer Unterkante der Basis.

Der vertikale Heterobipolartransistor gemäß Anspruch 1, nachfolgend auch kurz als Bipolartransistor, Transistor oder HBT benannt, zeichnet sich durch besonders gute Hochfrequenzeigenschaften aus. Diese werden erzielt durch eine besonders geringe parasitäre Basis-Kollektor-Kapazität, die aufgrund der erfindungsgemäßen Struktur des Bipolartransistors mit einem verringerten Widerstand des Basisanschlussgebietes einhergeht.

Eine geringe parasitäre Basis-Kollektor-Kapazität weist der erfindungsgemäße Bipolartransistor aufgrund der Gestaltung seines Basisanschlussgebiets auf. Von großer Bedeutung für diese vorteilhaften Eigenschaften ist der vertikal isolierte einkristalline Basisanschlussgebietsabschnitt, kurz VIEBAG-Abschnitt (englisch: vertically isolated monocrystalline outer base (VIMOB) region). Hierbei handelt es sich um einen Teil des Basisanschlussgebiets (BAG), der mit seiner zum Substratinneren weisenden Unterseite unmittelbar auf dem Isolationsgebiet des Bipolartransistors aufliegt und deswegen als vertikal isoliertes BAG bezeichnet wird.

Wesentlich für die Verringerung des Widerstands ist, dass der VIEBAG-Abschnitt zusätzliches leitfähiges Gebiet darstellt, das den Widerstand des Basisanschlussgebiets weiter verringert. Der VIEBAG-Abschnitt ermöglicht Stromfluss zur Basis zusätzlich von unten her, was einen gegenüber bekannten Lösungen bei geringer parasitärer Basis-Kollektor-Kapazität reduzierten Widerstand des Basisanschlussgebiets und damit des Basisgebiets insgesamt erzeugt.

Der VIEBAG-Abschnitt umgibt weiterhin den zweiten Höhenabschnitt der ersten Halbleiterelektrode lateral. Dies, in Verbindung mit der vertikalen Isolation zum Kollektor hin, reduziert parasitäre Basis-Kollektor-Kapazitäten. In einem Ausführungsbeispielen umschließt der VIEBAG-Abschnitt den zweiten Höhenabschnitt der ersten Halbleiterelektrode lateral unmittelbar (vgl. Beispiel 1 weiter unten). In einem anderen Ausführungsbeispiel umgibt er den zweiten Höhenabschnitt, wobei zwischen dem zweiten Höhenabschnitt und dem VIEBAG-Abschnitt prozessbedingt ein schmaler Lateralabschnitt des Basisanschlussgebiets mit Kristalldefekten liegt (vgl. Beispiel 3 weiter unten).

Die Grenze des ersten Höhenabschnitts der ersten Halbleiterelektrode in Höhenrichtung zum Substratinneren hin ist durch die Ausdehnung des lsolationsgebietes zum Substratinneren hin definiert. Die erste Halbleiterelektrode kann sich über diese Grenze hinaus zum Substratinneren hin auch unterhalb des Isolationsgebietes erstrecken, ohne also von diesem lateral umschlossen zu sein.

Als einkristallin werden hier Abschnitte bezeichnet, die eine einheitliche kristallographische Orientierung besitzen, die entweder durch das Substrat vorgegeben ist oder einer der anderen hochsymmetrischen Oberflächenorientierungen, im Falle des Siliziums den Oberflächenorientierungen (100), (110), (111) oder (311) entspricht. Im Gegensatz dazu werden als polykristalline Gebiete solche Gebiete bezeichnet, die aus einer Mehrzahl von Kristalliten mit verschiedenen kristallographischen Orientierungen bestehen, die in Korngrenzen aneinander grenzen und Ausdehnungen von einigen Nanometern bis zu einigen hundert Nanometern besitzen können.

Bei dem erfindungsgemäßen vertikalen Heterobipolartransistor ist die Lateralerstreckung desjenigen Höhenabschnitts des VIEBAG-Abschnitts, welcher den zweiten Höhenabschnitt der ersten Halbleiterelektrode lateral umgibt, größer als der in Höhenrichtung gemessene Abstand zwischen einer Oberkante des Isolationsgebietes und einer Unterkante der Basis. Auf diese Weise wird die geometrischen Anordnung des Basis-Kollektorüberganges eines Heterobipolartransistors für Höchstgeschwindigkeitsanwendungen optimiert.

Es wird angemerkt, dass aus der DE 39 01 881 A1 ein vertikaler Homo-Bipolartransistor ohne Heteroübergänge bekannt ist. Der Bipolartransistor der DE 39 01 881 A1 ist also kein Heterobipolartransistor, sondern ein Homo-Bipolartransistor (Homo-BJT). Mit dem Ziel, eine Verbesserung der Hochgeschwindigkeitseigenschaften eines solchen Homo-Bipolartransistors zu erzielen, wird in diesem Dokument vorgeschlagen, die vertikale Ausdehnung eines seitlich an die Basis grenzenden Basisanschlussgebietes so zu gestalten, dass ein so genannter Basiserweiterungsbereich auch im Hochstromfall (dort definiert durch die maximale Basis- Emitter-Spannung im Betriebsfall) von der Hochdotierung des Basisanschlussgebietes vollständig umschlossen wird.

Zur Erläuterung des Effektes der Basiserweiterung: Überschreitet bei einem npn-Transistor (sowohl bei einem Homo-BJT als auch bei einem HBT), die Elektronendichte in der Kollektorzone die Störstellenkonzentration, kommt es zu einer Basisverbreiterung. Diese wird in der Fachwelt als Base-Push-out-Effekt, Kirk-Effekt oder auch als Base-Widening-Effekt bezeichnet. In der DE 39 01 881 A1 wird hierfür auch der Begriff Basiserweiterung verwendet.

Bei einem Bipolartransistor mit kollektorseitigem Heteroübergang, der beispielsweise bei einem SiGe-Heterobipolartransistor praktisch stets vorliegt, kommt es wegen des Heteroüberganges bzw. der Heteroübergänge mit dem Einsetzen des Kirk-Effektes zu drastischen Geschwindigkeitsnachteilen. Mit dem Einsetzen dieses Effektes wird die Reaktionsfähigkeit des Transistors herabgesetzt. Bei Homo-Bipolartransistoren wie dem der DE 39 01 881 A1 hat jedoch eine Verbreiterung der Basis im Hochstromfall nicht die geschwindigkeitsmindernde Wirkung wie sie bei Hetero- und Doppel-Hetero-Bipolartransistoren eintritt.

Die Weiterentwicklung der Hochgeschwindigkeits-Bipolartransistoren nach Veröffentlichung der DE 39 01 881 A1 hat jedoch Änderungen mit sich gebracht, die die Anwendbarkeit der technischen Lehre dieses Dokuments in Frage stellen. Dies wird nachfolgend erläutert.

Aus Fig. 4 in D1 entnimmt man, dass die Basisweite nach dem damaligen Stand der Technik etwa 100 nm beträgt. Aus dieser Darstellung geht auch hervor, dass im Hochstromfall die "Basiserweiterung" Längen von 300nm annehmen kann. Dies würde der Dicke der niedrig dotierten Kollektorzone entsprechen.

Für Homo-Bipolartransistoren ging die Entwicklung inzwischen in Richtung kleinerer Basisweiten und höherer Dotierungskonzentrationen im niedriger dotierten Kollektorteil, und damit auch zu geringeren Längen der "Basiserweiterung". Typisch waren etwa die halben Werte der oben angegebenen Längen (ca. 50 nm Basisweite, ca. 150 nm niedrig dotierter Kollektor).

Die erhöhte Dotierstoffkonzentration im Kollektor hat aber den Einfluss der Basis-Kollektor-Kapazität (Collector-Base Capacitance, CBC) auf das Hochgeschwindigkeitsverhalten verstärkt und das Einsetzen des Kirk-Effektes zu höheren Stromdichten hin verschoben. Allein aus diesen Gründen werden auch beim Homo-BJT zwangsläufig verstärkt Maßnahmen gesucht, die CBC und den Basisanschlusswiderstand gleichzeitig zu senken.

Wäre man der technischen Lehre der DE 39 01 881 A1 weiter gefolgt, hätte man die vertikale Ausdehnung des Basisanschlussgebietes, welches ja den Basiserweiterungsbereich umschließen soll, mindestens auf 150 nm bringen müssen. Dies ist aber in der weiteren Entwicklung wegen des gestiegenen Einflusses der CBC nicht geschehen. Vielmehr ist das Gegenteil eingetreten. Es wurde bei Doppel-Poly-Konstruktionen wie der der oben beschriebenen Fig. 1 eine allenfalls geringfügige, meist jedoch keine Umschließung verwendet.

Dies gilt auch in noch verstärktem Maße für Heterobipolartransitoren. Bei Heterobipolartransistoren, insbesondere bei SiGe-Heterobipolartransistoren, gingen die inzwischen erzielten enormen Hochgeschwindigkeits-Fortschritte mit einer weiteren starken Reduktion der Basisweite auf Werte von < 30 bis 10 nm und mit einer Anhebung der Basis-Kollektor-Dotierung einher. Aus letzterem resultieren Weiten der Basis-Kollektor-Raumladungszone um oder unter 70 nm.

Bei einem HBT ist darüber hinaus aufgrund des Kirk-Effektes eine Verbreiterung der Basis um wenige nm (wie etwa weniger als 5 bis 10 nm) schon inakzeptabel. Eine markante Ausweitung der äußeren Basiszone als seitliche Umschließung des Kollektors, wie es in der DE 39 01 881 A1 als Fortschritt gegenüber dem damaligen Stand der Technik empfohlen wurde, ist beim HBT, insbesondere für Höchstgeschwindigkeitstransistoren, in der gezeigten Weise nicht vorteilhaft, sondern eher schädlich, weil die Kapazität zum Kollektor wesentlich erhöht wird. Bei einem Heterobipolartransistor führt die technische Lehre der DE 39 01 881 also nicht zu einer Verbesserung der Hochgeschwindigkeitseigenschaften, sondern zu einer Verschlechterung. Dadurch jedoch, dass beim erfindungsgemäßen Heterobipolartransistor die Lateralerstreckung des Höhenabschnitts des VIEBAG-Abschnitts, welcher den zweiten Höhenabschnitt der ersten Halbleiterelektrode lateral umgibt, größer als der in Höhenrichtung gemessene Abstand zwischen einer Oberkante des Isolationsgebietes und einer Unterkante der Basis ist, gelingt es, neben dem erfindungsgemäß erzielten geringen Widerstand des Basisanschlussgebiets zugleich eine wesentlich geringere Basis-Kollektor-Kapazität einzustellen, was die Herstellung von Heterobipolartransistoren mit besonders guten Hochfrequenzeigenschaften ermöglicht.

Nachfolgend werden bevorzugte Ausführungsbeispiele des erfindungsgemäßen Transistors beschrieben.

Bei einem Ausführungsbeispiel liegt derjenige Höhenabschnitt des VIEBAG-Abschnitts, welcher den zweiten Höhenabschnitt der ersten Halbleiterelektrode lateral umgibt, über eine Lateralerstreckung von mindestens 10 nm auf dem Isolationsgebiet auf.

Diese Lateralerstreckung beträgt in einem anderen Ausführungsbeispiel sogar mindestens 30 nm und weiter bevorzugt mindestens 70 nm. Bei diesen Ausführungsbeispielen ist der einkristalline Bereich besonders breit und wird somit ein besonders geringer Widerstand erzielt. In einem anderen Ausführungsbeispiel liegt der VIEBAG-Abschnitt, welcher den zweiten Höhenabschnitt der ersten Halbleiterelektrode lateral umgibt, über die gesamte Lateralerstreckung des Basisanschlussgebiets auf dem Isolationsgebiet auf, so dass sogar das gesamte Basisanschlussgebiet einkristallin und damit besonders widerstandsarm ausgebildet werden kann.

Bei einem weiteren Ausführungsbeispiel beträgt das Verhältnis zwischen der Lateralerstreckung des Höhenabschnitts des VIEBAG-Abschnitts, welcher den zweiten Höhenabschnitt der ersten Halbleiterelektrode lateral umgibt, und des in Höhenrichtung gemessenen Abstandes zwischen der Oberkante des Isolationsgebietes und der Unterkante der Basis zwischen mehr als 1 und 10.

Die Höhenerstreckung des Höhenabschnitts des VIEBAG-Abschnitts, welcher den zweiten Höhenabschnitt der ersten Halbleiterelektrode lateral umgibt, beträgt vorzugsweise zwischen 5 nm und 100 nm. Besonders bevorzugt ist ein Bereich zwischen 20 nm und 50 nm.

An den VIEBAG-Abschnitt kann auf seiner basisabgewandten Seite ein polykristalliner Lateralabschnitt des Basisanschlussgebiets angrenzen.

In einem anderen Ausführungsbeispiel grenzt der VIEBAG-Abschnitt aufgrund eines speziellen Herstellungsprozesses (vgl. Beispiel 4 weiter unten) basisseitig an einen mit ein- oder mehrdimensionalen Versetzungen oder Gitterfehlanpassungen versehenen, lateral sehr schmaler Bereich an.

Der VIEBAG-Abschnitt schließt in einem alternativen Ausführungsbeispiel (vgl. das Beispiel 1 weiter unten) auf seiner dem inneren Transistorgebiet zugewandten Seite in lateraler Richtung ohne ein- oder mehrdimensionale Versetzungen oder Gitterfehlanpassungen an die erste Halbleiterelektrode an.

Bei dem Isolationsgebiet handelt es sich bevorzugt um ein in einer Öffnung eines Feldisolationsgebietes angeordnetes Isolationsgebiet, das weiter unten auch als Isolationsgebiet 2. Art bezeichnet wird.

Die Höhenerstreckung des Isolationsgebietes liegt vorzugsweise im Bereich von 10nm bis 250nm, gemessen von der ursprünglichen Substratoberfläche aus. Es handelt sich bei dem Isolationsgebiet also um ein flaches Isolationsgebiet, das vorzugsweise sogar weniger tief in das Substrat hineinreicht als die Feldisolationsgebiete.

Das Isolationsgebiet weist in einem bevorzugten Ausführungsbeispiel eine Grube auf, die mit dem Material des Basisanschlussgebietes verfüllt ist. Die Ausbildung einer Grube bietet den Vorteil, dass aus dem hochdotierten, polykristallinen Teil des Basisanschlussgebietes Dotierstoff auch von der Substratseite her in Richtung der Basis, also des inneren Basisgebiets, vordringen kann.

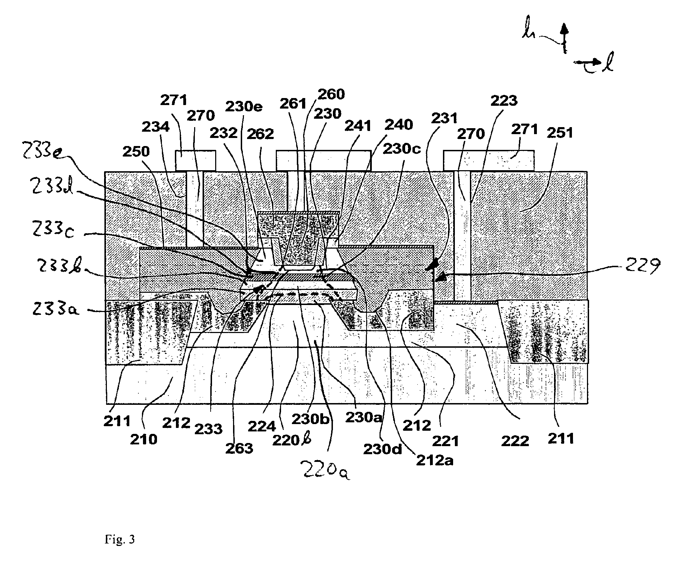

Bei einer anderen Ausführungsform verjüngt sich im Querschnitt gesehen der erste Höhenabschnitt der ersten Halbleiterelektrode zum zweiten Höhenabschnitt hin. Eine solche Konstruktion verbessert die Hochfrequenzeigenschaften durch Reduktion des Kollektorwiderstandes und durch verstärkte Wärmeabfuhr. Die Seitenwand des Isolatorgebietes kann auch stufenförmig oder gekrümmt sein, wobei sich die Weite des Kollektors zum Substrat hin vergrößert. Die Vorteile dieser Ausführungsform werden auch weiter unten anhand von Fig. 3 erläutert.

Bevorzugt ist, dass, im Querschnitt gesehen, die minimale laterale Erstreckung des sich verjüngenden ersten Höhenabschnitts der ersten Halbleiterelektrode gleichgroß wie, oder kleiner als die maximale laterale Erstreckung der zweiten Halbleiterelektrode.

Bei dieser Ausführungsform ist ein Rückwärtsbetrieb des erfindungsgemäßen Bipolartransistors möglich. Dazu ist durch entsprechend angepasste Dotierstoffkonzentrationen die erste Halbleiterelektrode als Emitter und die zweite Halbleiterelektrode als Kollektor ausgebildet.

Der vorliegend jedoch bevorzugte Fall ist der eines Vorwärtsbetriebs, bei dem die erste Halbleiterelektrode als Kollektor und die zweite Halbleiterelektrode als Emitter ausgebildet ist.

Bei einem weiteren Ausführungsbeispiel ist zwischen dem zweiten Höhenabschnitt der ersten Halbleiterelektrode und der Basis eine Pufferschicht aus einkristallinem Halbleitermaterial angeordnet. Es versteht sich, dass die Pufferschicht jedoch auch weggelassen werden kann.

Bei einem weiteren Ausführungsbeispiel ist zwischen der Basis und der zweiten Halbeiterelektrode eine Deckelschicht aus einkristallinem Halbleitermaterial angeordnet.

Der Emitter, allgemein die zweite Halbleiterelektrode, ist vorzugsweise, wie an sich bekannt, T-förmig.

Die vertikale Bipolartransistorstruktur der Erfindung kann auch auf einem SOI-Substrat hergestellt werden, wie weiter unten anhand der Beispiele 3 und 4 näher erläutert wird.

Bei dieser Ausführungsform ist der kristallographisch gesehen gestörte Lateralabschnitt des Basisanschlussgebiets lateral begrenzt und schließt auf seiner der Basis abgewandten Seite an dem einkristallinen Abschnitt des VIEBAG-Abschnitts an.

Die Gestalt der Seitenwand des an die erste Halbleiterelektrode grenzenden Isolatorgebietes kann senkrecht oder annähernd senkrecht zur Substratoberfläche verlaufen. In einer weiteren Ausgestaltung weist die innere Seitenwand des Isolatorgebietes eine Schräge auf, wodurch sich die Breite des Kollektorgebietes zum Substrat hin vergrößert. Eine solche Konstruktion verbessert die Hochfrequenzeigenschaften durch Reduktion des Kollektorwiderstandes und durch verstärkte Wärmeabfuhr. Die Seitenwand des Isolatorgebietes kann auch stufenförmig oder gekrümmt sein, wobei sich die Weite des Kollektors zum Substrat hin vergrößert.

In einer weiteren Ausgestaltung der erfindungsgemäßen Halbleiteranordnung werden im Kollektor gezielt Materialeigenschaften eingestellt, die die Form der Seitenwand des an den Kollektor grenzenden Isolatorgebietes beeinflussen. Dazu zählt in bevorzugten Ausführungsbeispielen die Einstellung von Dotierungsprofilen oder das Einbringen von Heteroschichten, die die Ätzbarkeit steuern. So kann die erste Halbleiterelektrode im erstem Höhenabschnitt oder im zweiten Höhenabschnitt eine Mehrzahl Schichten mit unterschiedlicher Materialzusammensetzung, beispielsweise SiGe-Schichten mit unterschiedlich hohem Ge-Gehalt, oder eine Mehrzahl Schichtabschnitte mit unterschiedlich hoher Dotierstoffkonzentration enthalten. Eine nähere Erläuterung der Vorteile dieses Ausführungsbeispiels wird weiter unten im Zusammenhang mit der Figurenbeschreibung gegeben.

In einer weiteren Ausgestaltung des erfindungsgemäßen Bipolartransistors kann die basisseitige Breite des Kollektors die Breite des Emitterfensters unterschreiten. Damit können gleichzeitig im Vorwärts- und im Rückwärtsbetrieb (der Kollektor übernimmt die Funktion des Emitters und umgekehrt) des vertikalen Bipolartransistors vorteilhafte Hochfrequenzeigenschaften erzielt werden.

Das dielektrisch isolierte, einkristalline Basisanschlussgebiet des erfindungsgemäßen Bipolartransistor kann sich auch auf der Oxidschicht einer SOI- (Silicon on Insulator) Substratscheibe befinden. Dabei sind in der Oxidschicht der SOI-Substratscheibe Zwischenräume eingebracht, die, mit Halbleitermaterial aufgefüllt, als Kollektorgebiet dienen. In diesem Fall kann das Basisanschlussgebiet nahezu vollständig aus einkristallinem Halbleitermaterial bestehen. Die an das Kollektorgebiet grenzende Seitenwand der Oxidschicht kann zum Substrat so gestaltet sein, dass sich das Kollektorgebiet verbreitert.

Die erfindungsgemäße Vorrichtung kann ohne Nachteile auch auf SOI-Substraten mit sehr dünnen Si-Deckschichten hergestellt werden, die insbesondere Schichtdicken von weniger als 50 nm aufweisen. Insbesondere entfällt die bei bekannten Anordnungen durch vergrabene Oxidschichten verschlechterte Wärmeabfuhr. Auch die Vergrößerung der Dicke der Si-Deckschichten während der Herstellung epitaktisch vergrabener Kollektoren tritt bei der erfindungsgemäßen Vorrichtung nicht auf. Daher kann die erfindungsgemäße Vorrichtung leicht mit so genannten "Fully-Depleted" oder "Partially-Depleted"-MOS-Transistoren kombiniert werden.

Bei der erfindungsgemäßen Halbleitervorrichtung kann es sich insbesondere um einen vertikalen Bipolartransistor mit epitaxialer oder implantierter Basis handeln.

Erfindungsgemäß werden zwei Alternativen des erfindungsgemäßen Heterobipolartransistors vorgeschlagen. Eine erste Alternative zur Herstellung des erfindungsgemäßen Heterobipolartransistors betrifft die Herstellung auf einem hochohmigen einkristallinen Halbleitersubstrat und hat die Schritte:
a) Bereitstellen eines hochohmigen einkristallinen Halbleitersubstrats (210) eines ersten Leitungstyps mit einem ersten Höhenabschnitt eines ersten Halbleiterelektrodengebiets (224) eines zweiten Leitungstyps,
b) Herstellen einer einkristallinen inselförmigen Podestschicht (225) über dem ersten Höhenabschnitt des ersten Halbleiterelektrodengebiets (224),
c) Ausbilden eines Grabens um die inselförmige Podestschicht (225) derart, dass die Podestschicht (225) schließlich auf einem Sockelbereich (220) des ersten Höhenabschnitts des ersten Halbleiterelektrodengebiets aufliegt und lateral über den Sockelbereich hinausragt,
d) Verfüllen des Grabens mit Isolatormaterial zur Herstellung eines Isolationsgebietes (212),
e) Differentiell epitaktisches Abscheiden eines Schichtstapels über der inselförmigen Podestschicht mit einer einkristallinen Basisschicht,
f) Ausbilden eines Basisgebiets und eines Basisanschlussgebiets durch Dotieren des Schichtstapels sowie Ausbilden eines zweiten Höhenabschnitts der ersten Halbleiterelektrode, der in lateraler Richtung auf die laterale Erstreckung des Sockelbereiches beschränkt ist,
   derart, dass das Basisanschlussgebiet (233; 320), einen einkristallinen Abschnitt (233a, 233b, 233c, 233d, 233e) aufweist, der in lateraler Richtung die Basis und den, von der Basis aus gesehen weiter zum Substratinneren liegenden, zweiten Höhenabschnitt (230a) der ersten Halbleiterelektrode (220; 326) lateral umgibt, und der mit seiner zum Substratinneren weisenden Unterseite unmittelbar auf dem Isolationsgebiet (212; 327) aufliegt, und der nachfolgend als vertikal isolierter einkristalliner Basisanschlussgebietsabschnitt, kurz VIEBAG-ABSCHNITT bezeichnet wird, und
g) Ausbilden einer zweiten Halbleiterelektrode des zweiten Leitfähigkeitstyps.

Zur näheren Erläuterung der Vorteile dieser Alternative des erfindungsgemäßen Verfahrens wird zum einen auf die Beschreibung der Vorteile des erfindungsgemäßen Heterobipolartransistors und zum andern auf die detaillierte Beschreibung eines Ausführungsbeispiels des Verfahrens in Form des Beispiels 2 weiter unten verwiesen.

Nachfolgend werden weitere bevorzugte Ausführungsbeispiele des erfindungsgemäßen Verfahrens beschrieben.

Bei einem Ausführungsbeispiel umfasst der Schritt des Bereitstellens eines hochohmigen einkristallinen Halbleitersubstrats eines ersten Leitungstyps mit einem ersten Höhenabschnitt eines ersten Halbleiterelektrodengebiet eines zweiten Leitungstyps die folgenden Unterschritte:
a1) Ausbilden mindestens eines Feldisolationsgebietes mit einer Öffnung, die einkristallines Halbleitermaterial enthält,
a2) Leitfähigkeitsdotierung zur Ausbildung von Halbleitermaterial eines zweiten Leitfähigkeitstyps für eine erste Halbleiterelektrode in der Öffnung.

Bei einem weiteren Ausführungsbeispiel wird im Isolationsgebiet vor dem Abscheiden des Basisschichtstapels eine an den inselförmigen Podestschicht lateral angrenzende Grube ausgebildet, die beim nachfolgenden Abscheiden des Basisschichtstapels verfüllt wird und Teil des Basisanschlussgebiets wird. Dieses Ausführungsbeispiel wird weiter unten bei der Beschreibung des Beispiels 2 näher erläutert.

Ein alternatives erfindungsgemäßes Verfahren zur Herstellung eines vertikalen Heterobipolartransistors betrifft die Verwendung eines Substrates mit einer vergrabenen Isolatorschicht, wie beispielsweise eines SOI-Substrates, und hat die Schritte:
a) Bereitstellen eines hochohmigen einkristallinen Halbleitersubstrats eines ersten Leitfähigkeitstyps mit einer vergrabenen Isolatorschicht,
b) Ausbilden von Öffnungen in der im Halbleitersubstrat vergrabenen Isolatorschicht,
c) Verfüllen der Öffnungen mit einkristallinem Halbleitermaterial und Dotieren des Halbleitermaterials im Bereich der Öffnungen und in Teilen des darunter liegenden Si-Substrates zum Herstellen eines ersten und eines darüber liegenden zweiten Höhenabschnitts eines ersten Halbleiterelektrodengebiets eines zweiten Leitfähigkeitstyps ,
d) Abscheiden eines Basisschichtstapels, der entweder insgesamt einkristallin ist oder einen sich in Höhenrichtung von der Oberseite der vergrabenen Isolatorschicht bis zur Oberseite des Basisschichtstapels erstreckenden, lateral begrenzten polykristallinen Lateralabschnitt hat,
e) Ausbilden eines Emitterfensters im Basisschichtstapel, dessen Öffnung sich über einen lateralen Abschnitt des Basisschichtstapels erstreckt, der kleiner ist als die Öffnung der Isolatorschicht,
f) Ausbilden einer Basis des ersten Leitfähigkeitstyps durch Dotieren des Basisschichtstapels in einem lateral durch die Öffnung des Emitterfensters begrenzten Bereich, und Ausbilden eines Basisanschlussgebiets durch Dotieren des Basisschichtstapels außerhalb des Emitterfensters
g) Ausbilden eines Emitters.

Durch den geschilderten Herstellungsprozess dieses alternativen Verfahrens gelingt es, Kristallstörungen am Übergang vom Kollektorgebiet zum Kollektorpodest, insbesondere in den überhängenden Si-Gebieten, zu vermeiden. Auf Basis dieses Verfahrens wird erreicht, dass die basisseitige Breite des Kollektorgebietes für eine bestimmte, festgehaltene Emitterbreite in deutlich weiteren Grenzen als im Vergleich zum Stand der Technik variiert werden kann, ohne dass Einschränkungen durch Zunahme der Basis-Kollektor-Randkapazität oder durch die Gefahr von Kristalldefekten im Emitterbereich zu befürchten sind. Das Basisanschlussgebiet liegt wenigstens abschnittsweise über dem Isolatorgebiet und weist dort wenigstens teilweise Abschnitte aus einkristallinem Halbleitermaterial auf. Diese Abschnitte des Basisanschlussgebietes werden im weiteren als dielektrisch isoliertes, einkristallines Basisanschlussgebiet bezeichnet.

Weitere Merkmale und Vorteile der Erfindung ergeben sich aus der nachfolgenden Beschreibung von Ausführungsbeispielen anhand der Figuren. Es zeigen:
- Fig. 1: zeigt den Querschnitt eines vertikalen Bipolartransistors nach dem Stand der Technik gefertigt in Doppel-Polysilizium-Technologie.
- Fig. 2: zeigt den Querschnitt eines vertikalen Bipolartransistors nach dem Stand der Technik gefertigt in Einfach-Polysilizium-Technologie.
- Fig. 3: zeigt eine Querschnittsansicht eines ersten Ausführungsbeispiels eines erfindungsgemäßen vertikalen Bipolartransistors.
- Fig. 4: zeigt den Querschnitt des erfindungsgemäßen, vertikalen Bipolartransistors während der Herstellung.
- Fig. 5: zeigt den Querschnitt des erfindungsgemäßen, vertikalen Bipolartransistors während der Herstellung.
- Fig. 6: zeigt den Querschnitt des erfindungsgemäßen, vertikalen Bipolartransistors während der Herstellung.
- Fig. 7: zeigt den Querschnitt des erfindungsgemäßen, vertikalen Bipolartransistors während der Herstellung.
- Fig. 8: zeigt den Querschnitt des erfindungsgemäßen, vertikalen Bipolartransistors während der Herstellung.
- Fig. 9: zeigt den Querschnitt des erfindungsgemäßen, vertikalen Bipolartransistors während der Herstellung.
- Fig. 10: zeigt den Querschnitt des erfindungsgemäßen, vertikalen Bipolartransistors auf SOI-Substratscheibe.
- Fig. 11: zeigt den Querschnitt des erfindungsgemäßen, vertikalen Bipolartransistors während der Herstellung auf SOI-Substratscheibe.
- Fig. 12: zeigt den Querschnitt des erfindungsgemäßen, vertikalen Bipolartransistors während der Herstellung auf SOI-Substratscheibe.
- Fig. 13: zeigt den Querschnitt des erfindungsgemäßen, vertikalen Bipolartransistors während der Herstellung auf SOI-Substratscheibe.
- Fig. 14: zeigt den Querschnitt des erfindungsgemäßen, vertikalen Bipolartransistors während der Herstellung auf SOI-Substratscheibe.
- Fig. 15: zeigt den Querschnitt des erfindungsgemäßen, vertikalen Bipolartransistors während der Herstellung auf SOI-Substratscheibe.
- Fig. 16: zeigt den Querschnitt des erfindungsgemäßen, vertikalen Bipolartransistors während der Herstellung auf SOI-Substratscheibe.

Es werden nachfolgend unter Bezug auf die jeweils genannten Figuren vier Beispiele beschrieben.

### Beispiel 1:

Ein erstes Ausführungsbeispiel einer erfindungsgemäßen Halbleitervorrichtung mit einem vertikalen Bipolartransistor, der ein dielektrisch isoliertes, partiell einkristallines Basisanschlussgebiet hat, wird nun unter Bezugnahme auf Fig. 3 erläutert. Fig. 3 zeigt eine Querschnittsansicht dieses ersten Ausführungsbeispiels.

In diesem Beispiel ist ein vertikaler npn-Bipolartransistor auf einem hochohmigen, einkristallinen p-leitfähigen Si-Substrat 210 gefertigt. Die hier beschriebene Anordnung ist jedoch nicht auf p-leitfähige Si-Substrate beschränkt. Die wesentlichen Merkmale können auch auf Substrate vom entgegengesetzten Leitfähigkeitstyp übertragen werden. Außerdem können gleichzeitig CMOS-Transistoren auf dem Substrat 210 vorhanden sein, sind aber in Figur 3 nicht dargestellt.

Der vertikale npn-Bipolartransistor der Fig. 3 umfasst einen n-leitenden Kollektor 220 und einen ebenfalls n-leitenden Emitter 260. Der Kollektor ist seitlich über ein Kollektoranschlussgebiet 221 und ein Kollektorkontaktgebiet 222 mit einem Kollektorkontakt 223 verbunden.

Zwischen Emitter 260 und Kollektor 220 ist ein Schichtstapel 229 angeordnet, der in einem inneren Bereich 230 einkristallin ist und sich seitlich nach außen hin als polykristalliner Schichtstapel 231 fortsetzt. Der Schichtstapel 229 enthält in seinem inneren Bereich 230 eine p-leitende Basisschicht 230c. Eine innere Basisschicht 232 wird als Abschnitt der Basisschicht 230c in horizontaler Richtung etwa durch die Breite des Emitterfensters 261 definiert. Seitlich ist die innere Basisschicht 232 über das Basisanschlussgebiet 233 mit dem Basiskontakt 234 verbunden. Das Basisanschlussgebiet 233 setzt sich aus einem einkristallinen Bereich des Schichtstapels 230 und dem weiter außerhalb liegenden Bereich des polykristallinen Stapels 231 zusammen.

Der einkristalline Schichtstapel 230 wird in drei Epitaxieschritten erzeugt. Der Schichtstapel 230 setzt sich aus fünf, nachfolgend beschriebenen Schichten 230a - 230e zusammen.

Über dem Kollektor 220 befindet sich eine einkristalline Si-Schicht 230a, die in einem ersten Epitaxieschritt entstanden ist. Sie kann eine Dicke von 5 nm bis 100 nm, vorzugsweise 20 nm bis 50 nm besitzen.

In einem zweiten Epitaxieschritt werden die Schichten 230b-d hergestellt. Durch differentielles Wachstum entsteht zunächst eine Pufferschicht 230b. Diese Schicht kann 5 nm bis 70 nm, vorzugsweise 5 nm bis 50 nm dick sein.

Oberhalb der Pufferschicht ist die p-dotierte Basisschicht 230c erzeugt. Die Dicke der Basisschicht kann 1 nm bis 100 nm, vorzugsweise 2 nm bis 35 nm betragen.

Über der Basisschicht folgt eine 10 nm bis 100 nm, vorzugsweise 10 nm bis 50 nm dicke Cap-Schicht 230d.

Seitlich vom Emitter und oberhalb der Cap-Schicht 230d ist in einem dritten Epitaxieschritt ein einkristalliner Abschnitt einer Basisanschlussverstärkung 230e entstanden. Die erzeugte Schichtdicke in vertikaler Richtung kann etwa 20 nm bis 150 nm, vorzugsweise 50 nm bis 120 nm betragen.

Eine erste Art Isolationsgebiete 211, im Weiteren als Feldisolationsgebiete bezeichnet, ragt ins Substratinnere hinein. Als Feldisolationsgebiete können sogenannte "Shallow-Trench"-Isolationen, wie sie aus CMOS-Technologien bekannt sind, eingesetzt werden. Dabei handelt es sich um vorzugsweise 250 bis 600 nm tiefe Gräben, die z.B. mit Siliziumdioxid (SiO₂), aber auch mit einer Kombination aus Isolatormaterial und Polysilizium verfüllt sein können. Alternativ können auch mittels lokaler Oxidation (LOCOS) hergestellte Feldisolationsgebiete eingesetzt werden. Zusätzlich zu den flachen Feldisolationsgebieten sind auch tiefe, z. B. mit SiO₂ verfüllte Gräben, sogenannte "Deep-Trenches", nutzbar, die jedoch in der Anordnung gemäß Fig. 3 nicht vorgesehen sind.

Eine zweite Art Isolationsgebiete 212, die in den Ansprüchen kurz als Isolationsgebiete bezeichnet werden, zeichnet sich gegenüber den Feldisolationsgebieten dadurch aus, dass der ins Substrat vergrabene Boden der Isolationsgebiete zweiter Art mit einer Tiefe von 10nm bis 200nm nicht die Unterkante der Feldisolationsgebiete 211 erreicht. Die Isolationsgebiete zweiter Art bestehen vorzugsweise aus einem Isolatormaterial mit kleiner Dielektrizitätskonstante. Dafür kann Siliziumdioxid (SiO₂) aber auch ein anderes, sogenanntes low-k-Material verwendet werden. Im Beispiel von Fig. 3 besteht das Isolationsgebiet zweiter Art 212 aus 2 Teilgebieten. Eines davon grenzt seitlich an das Feldisolationsgebiet 211 und überdeckt es teilweise. Es ist jedoch auch ohne wesentliche Auswirkungen auf die angestrebte Funktion möglich, dass das Isolationsgebiet 2. Art 212 keine Überlappung zum Feldisolationsgebiet 211 aufweist und dass die Oberkante des Isolationsgebietes 2. Art 212 sogar tiefer liegt die des Feldisolationsgebietes 211. Das zweite Isolationsgebiet 2. Art 212 liegt vollständig auf Substratgebiet. Die lsolationsgebiete zweiter Art 212 sind in der seitlichen Umgebung der einkristallinen Si-Schicht 230a mit Ätzgruben 212a versehen.

Zwischen den Isolationsgebieten zweiter Art 212 sind an der Substratoberfläche Inseln einkristalliner Silizium-Gebiete, in denen der vertikale npn-Bipolartransistor angeordnet ist. Er enthält einen im Substrat liegenden Kollektor 220, der seitlich im unteren Teil von den Seitenwänden der Feldisolationsgebiete 211 und weiter oben von den Isolationsgebieten zweiter Art 212 begrenzt wird. Durch Ausdiffusion von Dotierstoff im Verlaufe des Herstellungsprozesses kann sich die basisseitige Front der Kollektordotierung, die durch eine gestrichelte Linie 224 angedeutet ist, in das epitaktisch erzeugte Si-Gebiet 230a hineinschieben.

Das sich vom inneren Basisgebiet 232 her schräg nach außen verbreiternde Basisanschlussgebiet 233 besitzt einen auf den Isolationsgebieten zweiter Art 212 liegenden einkristallinen Abschnitt 233a bis 233e. Durch das Herstellungsverfahren wird sichergestellt, dass im Übergangsbereich vom Kollektor 220 zum Basisanschlussgebiet 233 keine Kristallstörungen vorhanden sind, wodurch eine gute Kontrolle der Ausdiffusion der Dotierstoffe aus Basisanschlussgebiet und Kollektor gewährleistet werden kann.

Die Ausbildung einer Ätzgrube 212a bietet den Vorteil, dass aus dem hochdotierten, polykristallinen Teils des Basisanschlussgebietes 233 Dotierstoff auch von der Substratseite aus in Richtung inneres Basisgebiet 232 vordringen kann.

Die Basis 230c kann vorzugsweise in eine Legierung von SiGe eingebracht werden. Außerdem kann in den Pufferschichten 230a,b oder in der Basisschicht 230c oder in der Cap-Schicht Kohlenstoff während der Epitaxie eingebaut worden sein.

Oberhalb des Schichtstapels 230, 231 befindet sich eine strukturierte Isolatorschicht 240. Diese kann vorzugsweise aus einer 10 nm bis 150 nm, vorzugsweise aus 30 nm bis 120 nm dicken SiO₂-Schich bestehen. Sie kann aber auch aus einer Kombination verschiedener Isolatormaterialien zusammengesetzt sein. Ein aus Isolationsmaterial bestehender Spacer 241 sichert die elektrische Isolation des Emitters 260 vom Basisanschlussgebiet 233.

Die von den Spacern 241 gebildete Öffnung über dem Schichtstapel 230 definiert das Emitterfenster 261. Eine hoch dotierte Siliziumschicht vom Leitungstyp des Kollektors, die npn-Emitterschicht 262, bedeckt das Emitterfenster 261 sowie die Isolatorschicht 240. Die npn-Emitterschicht 262 kann als polykristallines, amorphes, partiell einkristallines, partiell polykristallines oder als einkristallines Material abgeschieden sein. Aus der hoch dotierten npn-Emitterschicht 262 kann während eines Hochtemperaturschrittes n-Dotierstoff in den Schichtstapel 230 durch das Emitterfenster 261 eindiffundiert sein. Der Emitter 260 umfasst in diesem Fall die npn-Emitterschicht 262 sowie das eindiffundierte n-Gebiet 263.

In einem folgenden Silizierungsschritt entstehen die im Vergleich zu hochdotiertem Si noch besser leitfähigen Silizidschichten 250. Die Oberfläche der Transistor- und Isolationsgebiete wird mit einer Isolatorschicht oder -schichtkombination 251 abgedeckt. Mit leitfähigem Material verfüllte Kontaktlöcher 270 und darüber liegende Metallstreifen 271 stellen den elektrischen Anschluss zu den Kontaktgebieten des Transistors her.

### Beispiel 2:

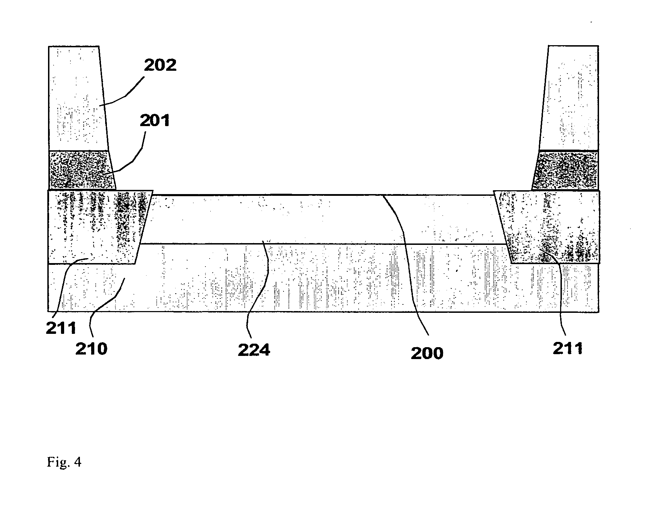

Es wird nun mit Bezug auf die Figuren 4 bis 9 ein Verfahren zur Herstellung der erfindungsgemäßen Halbleitervorrichtung, bestehend aus einem vertikalen Bipolartransistor mit dielektrisch isoliertem, partiell einkristallinen Basisanschlussgebiet, erläutert.

Fig. 4 zeigt eine Momentaufnahme während eines ersten Maskenschrittes zur Fertigung des vertikalen Bipolartransistors. Grundlage für die Herstellung bildet ein Substrat 210 (Fig. 4), das vorzugsweise ein möglichst hochohmiges, einkristallines p-leitendes (geringe p-leitende Dotierung) Silizium umfasst. Der Bearbeitungsprozess des Substrates 210 beginnt mit der Erzeugung der Feldisolationsgebiete 211. Im vorliegenden Beispiel werden als Feldisolationsgebiete sogenannte "Shallow Trenches" eingesetzt. Zwischen den Feldisolationsgebieten entstandene Inseln von Si-Gebieten bilden aktive Gebiete. Das aktive Gebiet 200 wird nach Fertigstellung des vertikalen Bipolartransistors den Kollektor, das Kollektoranschluss und Kollektorkontaktgebiet aufnehmen.

Der weitere Prozessablauf wird mit der Abscheidung einer Si₃N₄-Schicht 201 fortgesetzt. Diese Schicht dient später als Stopschicht während eines CMP-Schrittes. Anforderungen an die Dicke der Schicht ergeben sich aus späteren Darlegungen

Mit Hilfe einer Lackmaske 205 und üblichen anisotropen Trockenätzprozessen wird die Schicht 201 über dem aktiven Gebiet 200 und überlappend auf den Feldisolationsgebieten 211, geöffnet. Es ist jedoch auch möglich, anstelle der Schicht 201 einen Schichtstapel abzuscheiden und in Anwesenheit einer Lackmaske mittels Trocken- oder Nassätzung eine Deckelschicht des Schichtstapels und nach Lackentfernung die darunter liegende Schicht selektiv zu den restlichen Schichten mit nasschemischen Verfahren zu entfernen. Während dieses Prozessabschnittes wird eine n-Dotierung 224 per Implantation ins aktive Gebiet 200 eingebracht. Die Implantation der n-Dotierung 224 kann vor dem Entfernen der Lackmaske 202 erfolgen oder im Anschluss daran. Letzterer Fall ist möglich, wenn die Dicke der Schicht 201 oder eines möglichen Schichtstapels ausreicht, um eine unerwünschte Implantation anderer aktiver Gebiete zu verhindern.

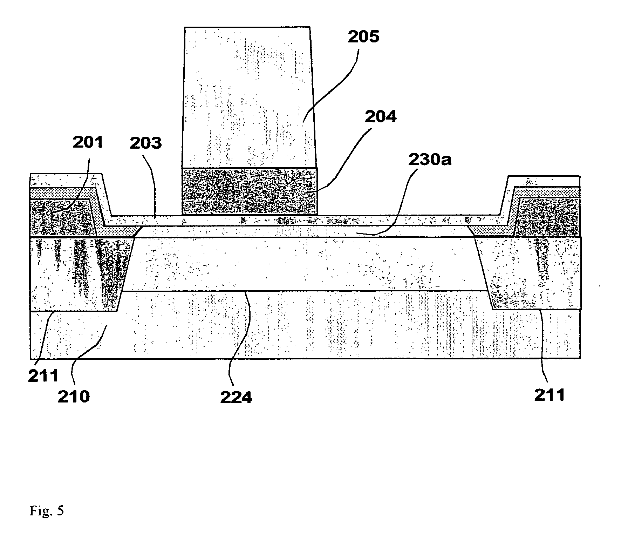

Nach Entfernung der Lackmaske 202 (vgl. Fig. 4) erfolgt ein Epitaxieschritt, bei dem eine einkristalline Si-Schicht 230a auf dem aktiven Gebiet 200 wächst (siehe Fig. 5). Gleichzeitig entsteht auf den Feldisolationsgebieten 211 und auf der Schicht 201 polykristallines Si. Die Dicke der Si-Schicht 230a kann zwischen 5 nm und 100 nm, vorzugsweise 20 nm bis 50 nm betragen. Danach wird ein Schichtstapel 203/204, bestehend aus SiO₂/Si₃N₄, abgeschieden. Mit Hilfe einer zuvor nach üblichen Verfahren strukturierten Lackmaske 205 werden bekannte Methoden für Trockenätzen angewendet, um den Schichtstapel 203/204 von den durch die Lackmaske nicht geschützten Gebieten zu entfernen.

Fig. 5 zeigt den Querschnitt eines Zwischenzustandes im Herstellungsprozess des vertikalen Bipolartransistors in einem Moment, in dem der Ätzprozess die Si₃N₄-Schicht bereits entfernt hat und die SiO₂-Schicht 203 erreicht hat. Im Zuge der Entfernung des Schichtstapels 203/204 wird auch die darunter liegende Si-Pufferschicht 230a und deren polykristalline Fortsetzung auf den Isolatorgebieten außerhalb des durch die Lackmaske 205 definierten lateralen Bereiches teilweise oder ganz entfernt. Es ist auch möglich, oberflächennahe Bereiche des Halbleitermaterials des aktiven Gebietes 200 außerhalb des maskierten Bereiches abzutragen. Die resultierende Gesamttiefe dieser Ätzung richtet sich nach Gesichtspunkten, die mit der späteren Aushöhlung unter dem mit der Lackmaske 205 abgedeckten Gebiet zusammenhängen.

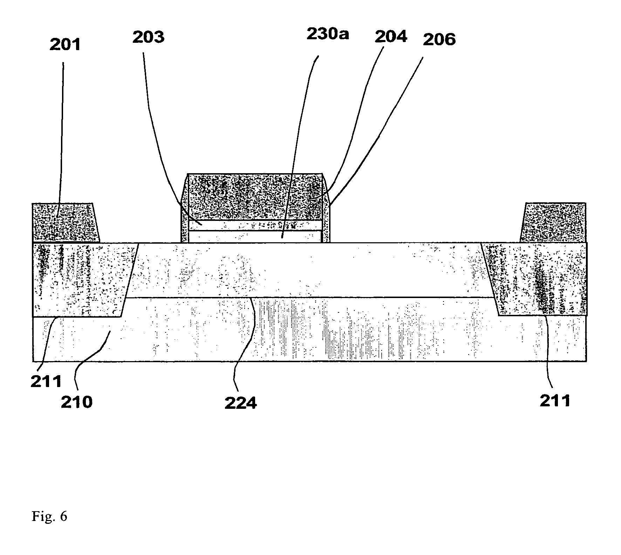

Um den Aushöhlungs- Schritt vorzubereiten, wird nach dem Entfernen der Lackmaske 205 an die geätzte Seitenwand des Schichtaufbaus 230a/203/204 ein Spacer 206, vorzugsweise aus Si₃N₄ bestehend, nach üblichen Methoden angebracht. Das Ergebnis dieser Prozessfolge ist in Fig. 6 dargestellt. In einem nun folgenden Ätzschritt wird zur Oberfläche hin freiliegendes Si abgetragen. Dabei können isotrope oder anisotrope oder die Kombination beider Ätztechniken zum Einsatz kommen. Ziel ist es, den Bereich unter dem mit dem Schichtstapel 203/204 abgedeckten Si-Gebiet auszuhöhlen, wobei an der Oberfläche ein überhängendes Si-Gebiet erhalten bleibt. Dieses Vorhaben wird einerseits durch die den seitlichen Ätzangriff verzögernden Spacer 206 unterstützt. Andererseits kann ein Selektivitätsunterschied zwischen der epitaktisch gewachsenen Si-Schicht 230a und dem implantierten Si-Gebiet 224 bei Anwendung geeigneter Ätzprozesse zum angestrebten Ziel führen.

Das Verhältnis von vertikalen und lateralen Ätzraten kann sowohl durch Dotierungsprofile als auch durch Materiallegierungen beeinflusst werden. So können z.B. SiGe-Schichten mit konstantem oder variablen Ge-Gehalt an der Substratoberfläche oder in der Schicht 230a (in diesem Beispiel nicht eingesetzt) so eingebracht werden, dass durch die hohe Selektivität bekannter Nass- oder Trockenätzverfahren (vgl. T.K. Carns, M. O. Tanner und K. L. Wang, "Chemical etching of Si1-xGex in HF:H2=2:CH3COOH", J. Electrochem. Soc., Vol. 142, No. 4, 1995) bezüglich Si und SiGe die angezielte Form des ausgehöhlten Gebietes erreicht wird.

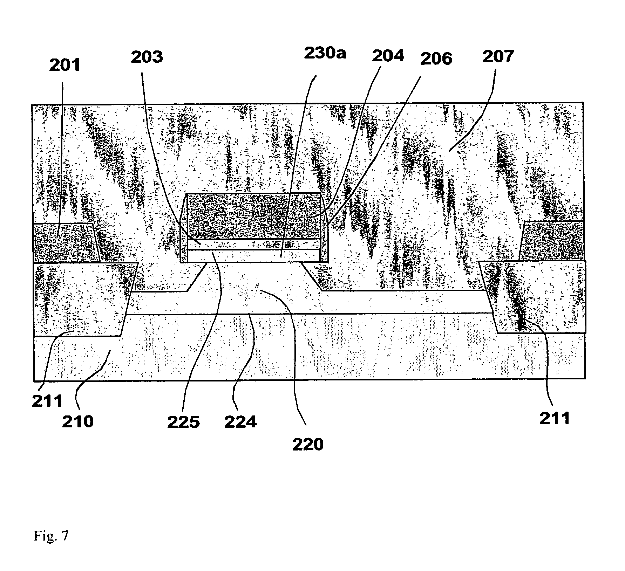

Eine vorteilhafte Ausgestaltung dieser Anordnung ist in Fig. 7 zu erkennen. Die vertikale Ausdehnung der zuletzt entstandenen Vertiefungen kann bezogen auf die ursprüngliche Substratoberfläche im Bereich von 10 nm bis 250 nm liegen, während das überhängende Si-Gebiet eine seitliche Ausdehnung von 10 nm bis zu einigen 100 nm erreichen kann.

Als Kollektorpodest 225 soll im weiteren dasjenige einkristalline Si-Gebiet bezeichnet werden, das in Fig. 7 vom Schichtstapel 203/204 bedeckt wird.

Das Kollektorpodest 225 besitzt in horizontaler Richtung, die in der Querschnittsansicht der Fig. 1 auch die erkennbare laterale Richtung ist, einen zentralen Bereich, der substratseitig an das implantierte Si-Gebiet 224 grenzt, sowie überhängende Abschnitte an den Seiten. Das sich zwischen den Vertiefungen ausbildende Si-Gebiet wird Teil des Kollektorgebietes 220.

In vertikaler Richtung zum Substratinneren hin ist eine Verbreiterung des zwischen den Vertiefungen liegenden Teils des Kollektorgebietes 220 zu verzeichnen. Dies wird z.B. dadurch bewirkt, dass bei isotropem Ätzverhalten die weiter in Richtung zur Oberfläche hin liegende seitliche Berandung des geätzten Gebietes dem Ätzmittel für eine größere Dauer ausgesetzt wird. Es ist auch möglich die Abhängigkeit der Ätzrate von der Dotierstoffkonzentration auszunutzen. Durch geeignete Wahl der Implantationsbedingungen für die n-Dotierung 224 lässt sich erreichen, dass in den oberen Abschnitten des Kollektorgebietes 220 eine größere Dotierstoffkonzentration vorhanden ist als in den unteren Abschnitten. Dieser Gradient der Dotierstoffkonzentration bewirkt, wie oben erläutert, tiefenabhängig unterschiedliche Verhältnisse vertikaler und horizontaler Ätzraten im Ätzprozess. Die so erzielte Gestalt wirkt sich günstig auf den Kollektorwiderstand und die Wärmeabfuhr aus. Das seitlich überhängende Si-Gebiet des Kollektorpodestes 225 wird im weiter außen befindlichen Bereich ein Teil des Basisanschlussgebietes.

Durch den geschilderten Herstellungsprozess gelingt es, Kristallstörungen am Übergang vom Kollektorgebiet 220 zum Kollektorpodest 225, insbesondere in den überhängenden Si-Gebieten, zu vermeiden. Auf Basis dieses Verfahrens wird erreicht, dass die basisseitige Breite des Kollektorgebietes 220 für eine bestimmte, festgehaltene Emitterbreite in deutlich weiteren Grenzen als im Vergleich zum Stand der Technik variiert werden kann, ohne dass Einschränkungen durch Zunahme der Basis-Kollektor-Randkapazität oder durch die Gefahr von Kristalldefekten im Emitterbereich zu befürchten sind.

Eine Ausgestaltungsvariante des erfindungsgemäßen vertikalen Bipolartransistors schließt auch die Möglichkeit ein, dass die minimale Breite des Kollektorgebietes 220 gleich groß ist wie die Breite des Emitterfensters oder kleiner als die Breite des Emitterfensters gestaltet ist.

In diesen Fällen ist auch ein rückwärts betriebene Transistor, bei dem ein Emitter unter dem Kollektor, also weiter zum Substratinneren liegt, eine weitere Ausgestaltungsmöglichkeit. Unter diesen Umständen sind die Dotierungsprofile für Emitter, Basis und Kollektor so zu wählen, dass die angestrebten Transistoreigenschaften im Rückwärtsbetrieb oder für beide Betriebsarten erreicht werden.

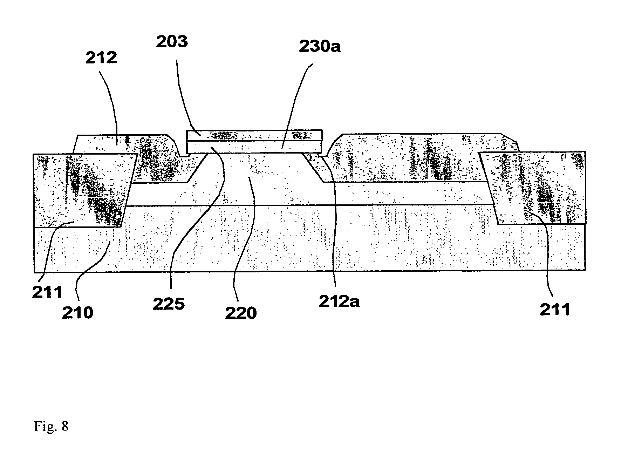

Wie in Fig. 7 dargestellt, werden nach der Herstellung des Kollektorpodestes 225 die entstandenen Vertiefungen mit SiO₂ gefüllt. Darüber hinaus wird eine ausreichend dicke SiO₂-Schi 207 abgeschieden, um mit Hilfe eines anschließenden chemisch-mechanischen Polier(CMP)-Schrittes Unebenheiten an der Oberfläche ausgleichen zu können. Die Schicht 201 dient dabei als Stoppschicht während des chemisch-mechanischen Poliervorganges. Durch die Höhe der Si₃N₄-Schicht 201 kann die nach dem Polierschritt verbleibende Höhe der Si₃N₄-Schicht 204 über dem Kollektorpodest bzw. die Höhe der Isolationsgebiete 212, auch Isolationsgebiete zweiter Art genannt, gesteuert werden (vgl. Fig. 8).

Fig. 8 zeigt den Querschnitt des vertikalen Bipolartransistors nach einer selektiven, nasschemischen Entfernung der Si₃N₄-Schichten 201, 204 und 206. Durch das Material und die Form der Spacer 206 kann erreicht werden, dass die Isolationsgebiete zweiter Art 212 in der seitlichen Umgebung des Kollektorpodestes 225 mit Ätzgruben 212a versehen werden. Diese mögliche, aber nicht notwendige Ausführungsform bietet den Vorteil, dass aus dem später erzeugten, hochdotierten Basisanschlussgebiet 233 (vgl. Fig. 3) Dotierstoff von der polykristallinen Schicht 231 aus auch von der Substratseite in Richtung inneres Basisgebiet 232 vordringen kann. Die Ausbildung der Ätzgruben wird z. B. unterdrückt, wenn die Spacer aus SiO₂ hergestellt werden.

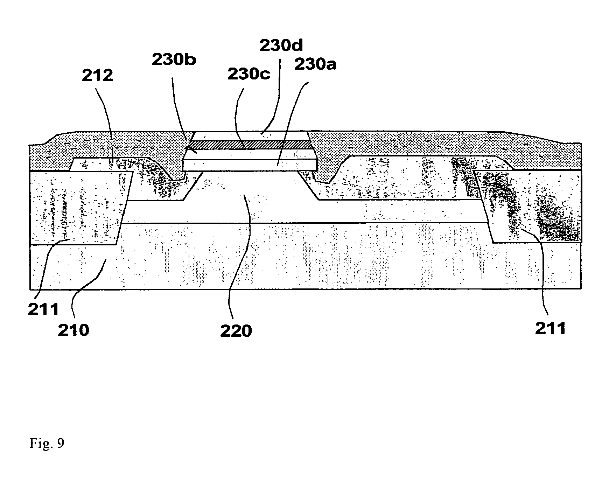

Fig. 9 zeigt ein Zwischenstadium der Herstellung des vertikalen Bipolartransistors nach der epitaktischen Abscheidung des einkristallinen Schichtstapels 230, der sich seitwärts als polykristalline Schicht 231 auf den Isolationsgebieten fortsetzt. Der differentielle Epitaxieschritt umfasst die Abscheidung der Pufferschicht 230b, der in situ mit Bor dotierten SiGe-Basisschicht 230c und der Cap-Schicht 230d. Anstelle der insitu eingebrachten Basisdotierung, kann die Basis auch per Implantation erzeugt werden.

Der weitere Prozessablauf zur Herstellung des vertikalen Bipolartransistors mit dielektrisch isoliertem, partiell einkristallinen Basisanschlussgebiet folgt bekannten Methoden. Dazu wird die in IHP.253 dargelegte Prozessschrittfolge zur Herstellung einer Emitterkonstruktion mit selbstpositionierten, mittels selektiver Epitaxie verstärkten Basisanschlussgebieten herangezogen.

### 3. Beispiel

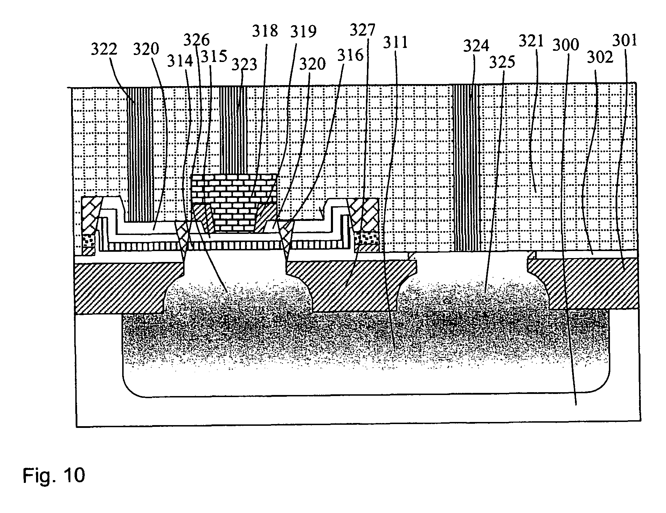

Ein weiteres Ausführungsbeispiel einer erfindungsgemäßen Halbleitervorrichtung wird nun in Bezug auf die Figur 10 beschrieben. Figur 10 zeigt eine Querschnittsansicht eines Bipolartransistors mit partiell einkristallinem Basisanschlussgebiet auf einem SOI-Substrat. Die SOI-Substratscheibe besteht aus einem Trägersubstrat aus Silizium 300, einer vergrabenen Oxidschicht 301 und einer Si-Deckschicht 302.

Der npn-Transistor dieses Ausführungsbeispiels umfasst einen n-leitenden Emitter 318, eine p-leitende Basis 314 und einen n-leitenden Kollektor 326. Der Kollektor ist über eine n-leitende Kollektorwanne 311 und ein n-leitendes Kollektoranschlussgebiet 325 zum Kollektorkontakt 324 geführt. Die vergrabene Oxidschicht 301 der SOI-Substratscheibe ist in den Kollektorgebieten 326 und in den Kollektoranschlussgebieten 325 unterbrochen. Diese unterbrochenen Bereiche der vergrabenen Oxidschicht sind durch epitaktisch abgeschiedenes einkristallines Silizium aufgefüllt. Insbesondere können die Kollektorgebiete 326 und die Kollektoranschlussgebiete 325 durch einen verbleibenden Teil der vergrabenen Oxidschicht 327 voneinander getrennt sein oder in einem gemeinsamen Fenster in der vergrabenen Oxidschicht ausgebildet werden. Die Umrandung der geöffneten Fenster in der vergrabenen Oxidschicht kann insbesondere so gestaltet sein, dass die Größe der Fenster mit zunehmender Tiefe zunimmt. Dadurch wird ein geringer Kollektorwiderstand ermöglicht. Eine Umrandung des in der vergrabenen Oxidschicht durch eine senkrechte Grenzfläche zwischen Silizium und Siliziumdioxid ist ebenfalls möglich.

Oberhalb des Kollektorgebietes 326 ist eine epitakxiale Basisschicht angeordnet, die eine p-Dotierung enthält. Insbesondere kann die epitaxiale Basisschicht eine SiGe-Schicht 314 einschließen. Beispielsweise kann die epitaxiale Basisschicht eine Schichtfolge Si/SiGe/Si umfassen. Zusätzlich kann die epitaxiale Basisschicht mit Kohlenstoff dotiert sein. Die epitaxiale Basisschicht kann besonders vorteilhaft durch differentielle Epitaxie hergestellt werden. Dabei wächst die Schicht auf kristallinen Silizium-Gebieten einkristallin und auf mit Isolatorschichten bedeckten Gebieten polykristallin.

Der erfindungsgemäße Bipolartransistor zeichnet sich dadurch aus, dass der Teil des Basisgebietes, der durch die vergrabene Oxidschicht 301 von dem Kollektor 326 dielektrisch isoliert ist, teilweise oder vollständig einkristallin ist. Das einkristalline Wachstum der Basisschicht oberhalb der vergrabenen Oxidschicht 301 wird durch die auf der vergrabenen Oxidschicht befindliche Siliziumschicht 302 ermöglicht. Die einkristalline Struktur der Basisschicht auch in den Bereichen, die von dem Kollektorgebiet 326 durch die vergrabene Oxidschicht 301 dielektrisch isoliert sind, führt zu einem besonders geringem elektrischem Widerstand dieser Schicht und damit zu verbesserten Hochfrequenzeigenschaften des Transistors. Entlang der Umrandung des Kollektorgebietes 326 kann das einkristalline Wachstum der Basisschicht in einem beschränkten Gebiet 316 gestört sein.

Oberhalb der epitaxialen Basisschicht ist der Emitter 318 angeordnet. Der Emitter besteht aus n⁺-dotiertem Si, welches einkristallin oder polykristallin sein kann. Der Emitter wird lateral durch Abstandshalter 319 begrenzt, die aus Siliziumdioxid oder aus einem anderen Isolatormaterial bestehen. Der Emitter wird durch den Kontakt 323 angeschlossen.

### Beispiel 4

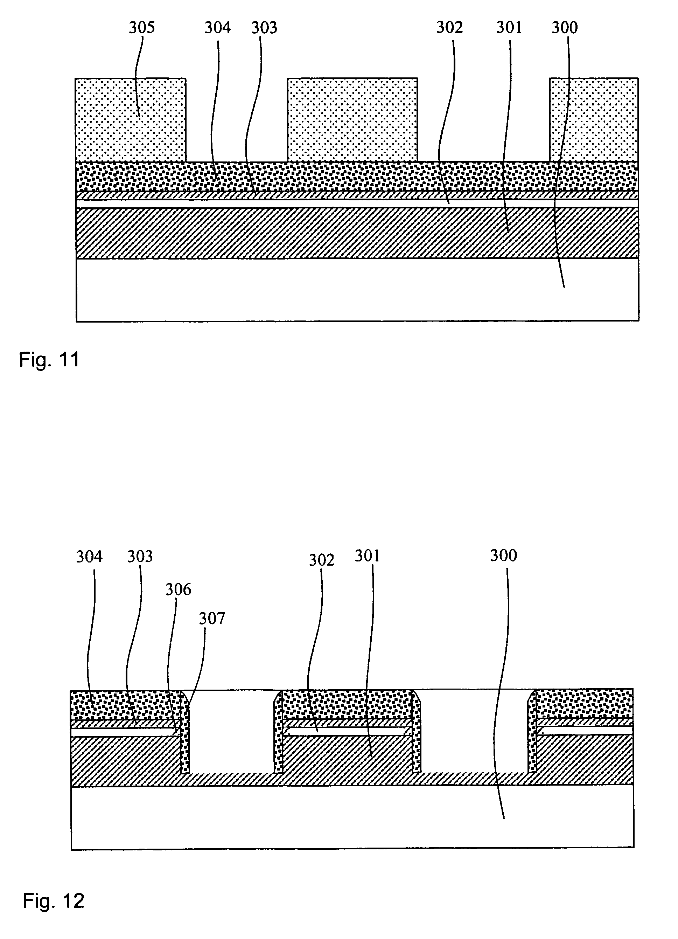

Im Folgenden wird ein bevorzugtes Verfahren zur Herstellung des in Figur 10 dargestellten Transistors in Bezug auf die Figuren 11 bis 16 erläutert. Auf der aus einem Trägersubstrat aus Silizium 300, einer vergrabenen Oxidschicht 301 und einer Si-Deckschicht 302 bestehenden SOI-Scheibe wird durch thermische Oxidation oder durch ein Abscheideverfahren eine Siliziumdioxidschicht 303 erzeugt. Auf dieser Siliziumdioxidschicht wird eine Siliziumnitridschicht 304 abgeschieden (Figur 11).

In weiteren Schritten werden mit Hilfe einer Lackmaske 305 die lateralen Erstreckungen der Kollektorgebiete 326 und Kollektoranschlussgebiete 325 definiert. Über eine Folge von RIE-Prozessen werden die Siliziumnitridschicht 304, die Siliziumdioxidschicht 303 und die Si-Schicht 302 in den offenen Gebieten entfernt. Die vergrabene Oxidschicht 301 wird in diesen Bereichen teilweise entfernt (Figur 12). Dafür kann beispielsweise ein weiterer RIE-Prozess genutzt werden. In einem weiteren Schritt werden die entlang der Umrandungslinie dieser geöffneten Fenster freigelegten Schnittflächen der Si-Schicht 302 beispielsweise durch thermische Oxidation mit Siliziumdioxid 306 bedeckt. Anschließend werden mit Hilfe von dem bekannten Stand der Technik entsprechenden Verfahren Spacer aus Siliziumnitrid 307 an den Innflächen der geöffneten Fenster gebildet (Figur 12).

In einem weiteren Schritt wird der in den Bereichen der geöffneten Fenster verbliebene Teil der vergrabenen Oxidschicht 301 beispielsweise durch ein Nass-ätzverfahren entfernt. Durch eine Unterätzung der Nitridspacer 307 kann in einer bevorzugten Ausführung des Verfahrens eine nach unten hin zunehmende Größe der Fenster realisiert werden. Anschließend werden die Nitridschicht 304 und die Spacer 307 beispielsweise mit Hilfe eines Nassätzverfahrens entfernt.

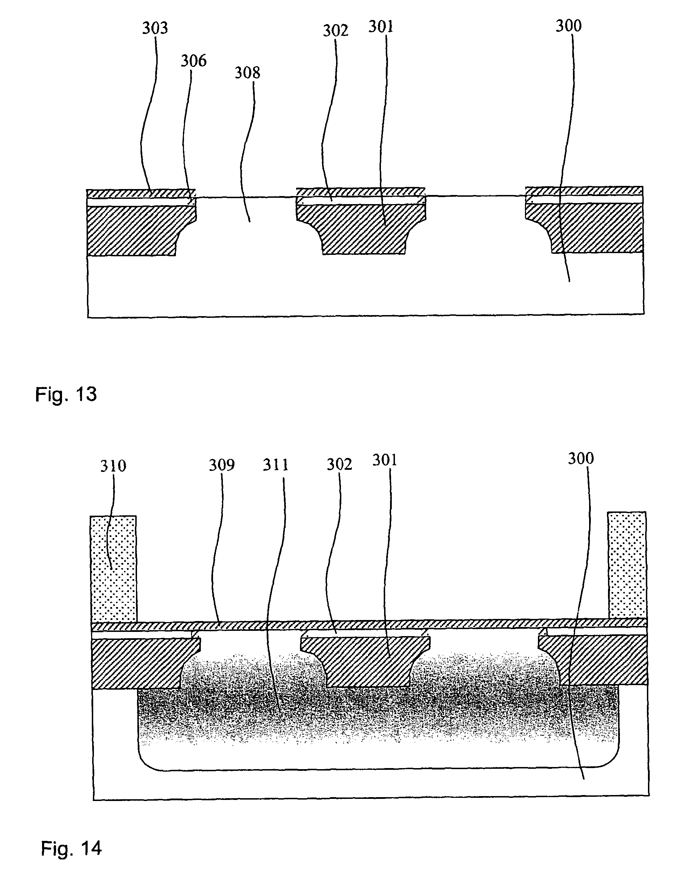

In einem weiteren Schritt werden auf den in den geöffneten Fenstern freigelegten Si-Oberflächen des Trägersubstrats 300 einkristalline Siliziumschichten 308 abgeschieden (Figur 13). Dafür kann vorzugsweise ein selektives Epitaxieverfahren eingesetzt werden. In einer bevorzugten Ausführung des Verfahrens wird anschließend auf der derartig strukturierten Scheibe eine Oxidschicht 309 abgeschieden.

In einem weiteren Schritt werden mittels einer Lackmaske die Kollektor- und Kollektoranschlussgebiete durch Implantation von Donatorionen (Phosphor, Arsen oder Antimon) dotiert (Figur 14). In einer bevorzugten Ausführung der Erfindung sind das Kollektorgebiet 326 und das Kollektoranschlussgebiet 325 durch einen verbliebenen Teil der vergrabenen Oxidschicht 301 voneinander getrennt. In diesem Fall wird die Energie der implantierten Ionen so gewählt, dass die n-leitende Kollektorwanne 311 die Kollektorgebiete und Kollektoranschlussgebiete elektrisch verbindet.

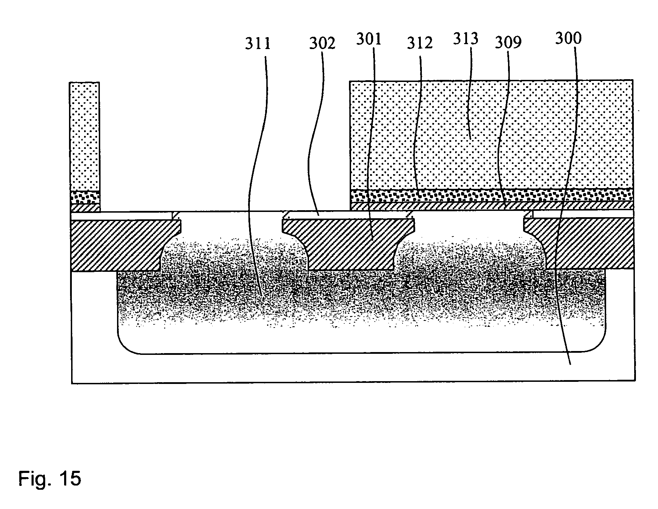

In einem folgenden Schritt wird auf der Scheibe eine weitere Isolatorschicht 312 abgeschieden, die beispielsweise aus Siliziumnitrid besteht. Mittels einer Lackmaske 313 werden die auf der Si-Oberfläche befindlichen Isolatorschichten 309 und 312 über den Kollektorbereichen 326 und über den angrenzenden Basisanschlussgebieten geöffnet (Figur 15).

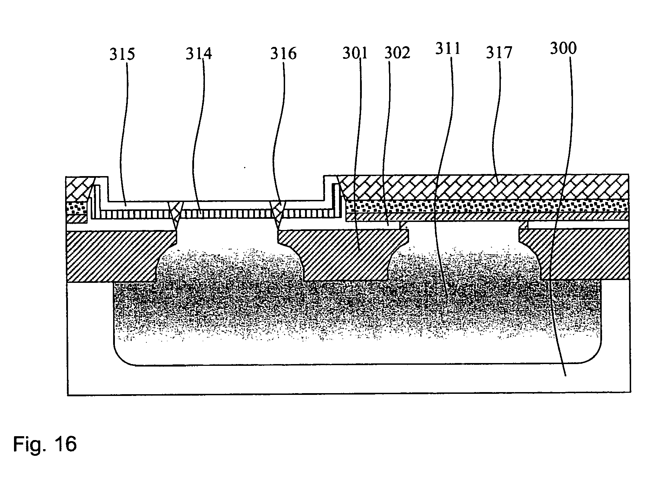

In einem weiteren Schritt wird die Basisschicht vorzugsweise mit einem differentiellen Epitaxieverfahren abgeschieden. Insbesondere kann die epitaxiale Basisschicht eine SiGe-Schicht 314 und eine Deckschicht aus Silizium 315 einschließen (Figur 16). Auf den mit Isolatorschichten 309 und 312 bedeckten Gebieten der Scheibe erfolgt in dieser Ausführung der Erfindung ein polykristallines Wachstum der Basisschicht. Auf den freigelegten Siliziumoberflächen in den Kollektor- und Basisanschlussgebieten erfolgt ein vorzugsweise einkristallines Wachstum der Basisschicht. Entlang der Umrandung des Kollektorgebietes 326 kann das einkristalline Wachstum der Basisschicht in einem beschränkten Gebiet 316 gestört sein.

In weiteren Schritten des Verfahrens werden mit Hilfe von dem bekannten Stand der Technik entsprechenden Verfahren Emitter 319 abgeschieden und strukturiert und werden die Emitter-, Basis- und Kollektorgebiete kontaktiert (Figur 10). In einer bevorzugten Ausführung des Verfahrens erfolgt die Herstellung des Emitters und der externen Basisregion nach dem im Ausführungsbeispiel 2 beschriebenen Verfahren.

## Patentansprüche

1. Vertikaler Heterobipolartransistor,
mit einem Substrat (210; 300) aus Halbleitermaterial eines ersten Leitfähigkeitstyps und einem darin ausgebildeten Isolationsgebiet (212; 327),
- einer in einer Öffnung des Isolationsgebietes (212;327) angeordneten ersten Halbleiterelektrode (220; 326) aus einkristallinem Halbleitermaterial eines zweiten Leitfähigkeitstyps, die entweder als Kollektor oder als Emitter ausgebildet ist, und die einen ersten Höhenabschnitt (220a) aufweist, der vom Isolationsgebiet in zu einer Höhenrichtung (h) senkrecht stehenden lateralen Richtungen (I) umschlossen ist und einen angrenzenden, in der Höhenrichtung (h) vom Substratinneren weiter entfernten zweiten Höhenabschnitt (230a) aufweist, der lateral nicht vom Isolationsgebiet umschlossen ist,
- einer zweiten Halbleiterelektrode (260; 318) aus Halbleitermaterial des zweiten Leitfähigkeitstyps, die als der andere Typ Halbleiterelektrode, also als Emitter beziehungsweise alternativ als Kollektor ausgebildet ist,
- einer Basis (230c; 314) aus einkristallinem Halbleitermaterial des ersten Leitfähigkeitstyps zwischen dem Kollektor und dem Emitter, und
- einem Basisanschlussgebiet (233; 320), das einen einkristallinen Abschnitt (233a, 233b, 233c, 233d, 233e) aufweist, der in lateraler Richtung den, von der Basis aus gesehen weiter zum Substratinneren liegenden, zweiten Höhenabschnitt (230a) der ersten Halbleiterelektrode (220; 326) lateral umgibt, und der mit seiner zum Substratinneren weisenden Unterseite unmittelbar auf dem Isolationsgebiet (212; 327) aufliegt, und der nachfolgend als Vertikal Isolierter Einkristalliner BasisanschlussgebietsAbschnitt, kurz VIEBAG-Abschnitt bezeichnet wird,
**dadurch gekennzeichnet dass** die Lateralerstreckung eines Höhenabschnitts (233a) des VIEBAG-Abschnitts (233a, 233b, 233c, 233d, 233e), welcher den zweiten Höhenabschnitt (230a) der ersten Halbleiterelektrode (220) lateral umgibt, größer ist als der in Höhenrichtung gemessene Abstand zwischen einer Oberkante des Isolationsgebietes (212) und einer Unterkante der Basis (230c).

2. Vertikaler Bipolartransistor nach Anspruch 1, bei dem derjenige Höhenabschnitt (233a) des VIEBAG-Abschnitts (233a, 233b, 233c, 233d, 233e), welcher den zweiten Höhenabschnitt (230a) der ersten Halbleiterelektrode (220) lateral umgibt, über eine Lateralerstreckung von mindestens 10 nm auf dem Isolationsgebiet (212; 327) aufliegt.

3. Vertikaler Bipolartransistor nach Anspruch 1, bei dem derjenige Höhenabschnitt (233a) des VIEBAG-Abschnitts (233a, 233b, 233c, 233d, 233e), welcher den zweiten Höhenabschnitt (230a) der ersten Halbleiterelektrode (220) lateral umgibt, über eine Lateralerstreckung von mindestens 30 nm auf dem Isolationsgebiet (212; 327) aufliegt.

4. Vertikaler Bipolartransistor nach Anspruch 1, bei dem derjenige Höhenabschnitt (233a) des VIEBAG-Abschnitts (233a, 233b, 233c, 233d, 233e), welcher den zweiten Höhenabschnitt (230a) der ersten Halbleiterelektrode (220) lateral umgibt, über eine Lateralerstreckung von mindestens 70 nm auf dem Isolationsgebiet (212; 327) aufliegt.

5. Vertikaler Bipolartransistor nach einem der vorstehenden Ansprüche, bei dem derjenige Höhenabschnitt (233a) des VIEBAG-Abschnitts (233a, 233b, 233c, 233d, 233e), welcher den zweiten Höhenabschnitt (230a) der ersten Halbleiterelektrode (220) lateral umgibt, über die gesamte Lateralerstreckung des Basisanschlussgebiets auf dem Isolationsgebiet (212; 327) aufliegt, und bei dem das gesamte Basisanschlussgebiet einkristallin ausgebildet ist.

6. Vertikaler Bipolartransistor nach Anspruch 1, bei dem das Verhältnis zwischen der Lateralerstreckung des Höhenabschnitts (233a) des VIEBAG-Abschnitts (233a, 233b, 233c, 233d, 233e), welcher den zweiten Höhenabschnitt (230a) der ersten Halbleiterelektrode (220) lateral umgibt, und des in Höhenrichtung gemessenen Abstandes zwischen der Oberkante des Isolationsgebietes (212) und der Unterkante der Basis (230c) zwischen mehr als 1 und 10 beträgt.

7. Vertikaler Bipolartransistor nach einem der vorstehenden Ansprüche, bei dem die Höhenerstreckung des Höhenabschnitts (233a) des VIEBAG-Abschnitts (233a, 233b, 233c, 233d, 233e), welcher den zweiten Höhenabschnitt (230a) der ersten Halbleiterelektrode (220) lateral umgibt zwischen 5nm und 100nm beträgt.

8. Vertikaler Bipolartransistor nach einem der vorstehenden Ansprüche, bei dem die Höhenerstreckung des Höhenabschnitts (233a) des VIEBAG-Abschnitts (233a, 233b, 233c, 233d, 233e), welcher den zweiten Höhenabschnitt (230a) der ersten Halbleiterelektrode (220) lateral umgibt zwischen 20nm und 50nm beträgt.

9. Vertikaler Bipolartransistor nach einem der vorstehenden Ansprüche, bei dem an den VIEBAG-Abschnitt (233a, 233b, 233c, 233d, 233e) auf seiner basisabgewandten Seite ein polykristalliner Lateralabschnitt (231; 316) des Basisanschlussgebiets angrenzt.

10. Vertikaler Bipolartransistor nach Anspruch 1, bei dem der VIEBAG-Abschnitt in lateraler Richtung ohne ein- oder mehrdimensionale Versetzungen oder Gitterfehlanpassungen an die erste Halbleiterelektrode anschließt.

11. Vertikaler Bipolartransistor nach einem der vorstehenden Ansprüche, bei dem das Isolationsgebiet (212) in einer Öffnung eines Feldisolationsgebietes (211) angeordnet ist.

12. Vertikaler Bipolartransistor nach einem der vorstehenden Ansprüche, bei dem die Höhenerstreckung des Isolationsgebietes im Bereich von 10nm bis 250nm liegt.

13. Vertikaler Bipolartransistor nach einem der vorstehenden Ansprüche, bei dem das Isolationsgebiet eine Grube aufweist, die mit dem Material des Basisanschlussgebietes verfüllt ist.

14. Vertikaler Bipolartransistor nach einem der vorstehenden Ansprüche, bei dem sich, im Querschnitt gesehen, der erste Höhenabschnitt der ersten Halbleiterelektrode (220) zum zweiten Höhenabschnitt (230a) hin verjüngt.

15. Vertikaler Bipolartransistor nach Anspruch 14, bei dem, im Querschnitt gesehen, die minimale laterale Erstreckung des sich verjüngenden ersten Höhenabschnitts (220) der ersten Halbleiterelektrode gleichgroß ist wie, oder kleiner ist als die maximale laterale Erstreckung der zweiten Halbleiterelektrode (260).

16. Vertikaler Bipolartransistor nach Anspruch 15, bei dem die erste Halbleiterelektrode als Emitter und die zweite Halbleiterelektrode als Kollektor ausgebildet ist und der Bipolartransistor damit für einen Rückwärtsbetriebsmodus ausgebildet ist.

17. Vertikaler Bipolartransistor nach einem der Ansprüche 1 bis 15, bei dem die erste Halbleiterelektrode (220) als Kollektor und die zweite Halbleiterelektrode (260) als Emitter ausgebildet ist.

18. Vertikaler Bipolartransistor nach einem der vorstehenden Ansprüche, bei dem zwischen dem zweiten Höhenabschnitt (230a) der ersten Halbleiterelektrode und der Basis (230c) eine Pufferschicht (230b) aus einkristallinem Halbleitermaterial angeordnet ist.

19. Vertikaler Bipolartransistor nach einem der vorstehenden Ansprüche, bei dem zwischen der Basis (230c) und der zweiten Halbeiterelektrode (260) eine Deckelschicht (230d) aus einkristallinem Halbleitermaterial angeordnet ist.

20. Vertikaler Bipolartransistor nach einem der vorstehenden Ansprüche, bei dem die zweite Halbleiterelektrode T-förmig ist.

21. Vertikaler Bipolartransistor nach einem der vorstehenden Ansprüche, bei dem die erste Halbleiterelektrode im erstem Höhenabschnitt (220a) oder im zweiten Höhenabschnitt (230a) eine Mehrzahl Schichten mit unterschiedlicher Materialzusammensetzung oder eine Mehrzahl Schichtabschnitte mit unterschiedlich hoher Dotierstoffkonzentration enthält.

22. Vertikaler Bipolartransistor nach einem der vorstehenden Ansprüche, bei dem das Substrat ein SOI-Substrat ist.

23. Vertikaler Bipolartransistor nach Anspruch 22, bei dem eine Silizium-Deckschicht des SOI-Substrats eine Dicke von weniger als 50 nm hat.

24. Vertikaler Bipolartransistor nach Anspruch 22 oder 23, bei dem ein ein-oder mehrdimensionale Versetzungen oder Gitterfehlanpassungen aufweisender Lateralabschnitt (316) des Basisanschlussgebiets durch den VIEBAG-Abschnitt lateral begrenzt ist und auf seiner (316) der Basis abgewandten Seite ein zweiter einkristalliner Abschnitt des Basisanschlussgebiets anschließt.

25. Vertikaler Bipolartransistor nach Anspruch 23 oder 24, bei dem der polykristalline Lateralabschnitt (316) des Basisanschlussgebiets eine laterale Erstreckung von maximal 80 nm hat.

26. Verfahren zur Herstellung eines vertikalen Heterobipolartransistors, der die Merkmale eines der Ansprüche 1 bis 21 hat, mit den Schritten:
a) Bereitstellen eines hochohmigen einkristallinen Halbleitersubstrats (210) eines ersten Leitungstyps mit einem ersten Höhenabschnitt eines ersten Halbleiterelektrodengebiets (224) eines zweiten Leitungstyps,
b) Herstellen einer einkristallinen inselförmigen Podestschicht (225) über dem ersten Höhenabschnitt des ersten Halbleiterelektrodengebiets (224),
c) Ausbilden eines Grabens um die inselförmige Podestschicht (225) derart, dass das die Podestschicht (225) schließlich auf einem Sockelbereich (220) des ersten Höhenabschnitts des ersten Halbleiterelektrodengebiets aufliegt und lateral über den Sockelbereich hinausragt,
d) Verfüllen des Grabens mit Isolatormaterial zur Herstellung eines Isolationsgebietes (212),
e) Differentiell epitaktisches Abscheiden eines Schichtstapels über der inselförmigen Podestschicht mit einer einkristallinen Basisschicht,
f) Ausbilden eines Basisgebiets und eines Basisanschlussgebiets durch Dotieren des Schichtstapels sowie Ausbilden eines in lateraler Richtung auf die laterale Erstreckung des Sockelbereiches beschränkten zweiten Höhenabschnitts der ersten Halbleiterelektrode,
derart, dass das Basisanschlussgebiet (233; 320), einen einkristallinen Abschnitt (233a, 233b, 233c, 233d, 233e) aufweist, der in lateraler Richtung die Basis und den, von der Basis aus gesehen weiter zum Substratinneren inneren liegenden, zweiten Höhenabschnitt (230a) der ersten Halbleiterelektrode (220; 326) lateral umgibt, und der mit seiner zum Substratinneren weisenden Unterseite unmittelbar auf dem Isolationsgebiet (211; 327) aufliegt, und der nachfolgend als vertikal isolierter einkristalliner Basisanschlussgebietsabschnitt, kurz VIEBAG-Abschnitt bezeichnet wird, und
g) Ausbilden einer zweiten Halbleiterelektrode des zweiten Leitfähigkeitstyps.

27. Verfahren nach Anspruch 26, bei dem der Schritt des Bereitstellens eines hochohmigen einkristallinen Halbleitersubstrats (210) eines ersten Leitungstyps mit einem ersten Höhenabschnitt eines ersten Halbleiterelektrodengebiet (224) eines zweiten Leitungstyps die folgenden Unterschritte umfasst
a1) Ausbilden mindestens eines Feldisolationsgebietes (211) mit einer Öffnung (200), die einkristallines Halbleitermaterial (224) enthält,
a2) Leitfähigkeitsdotierung zur Ausbildung von Halbleitermaterial (224) eines zweiten Leitfähigkeitstyps für eine erste Halbleiterelektrode in der Öffnung (200).

28. Verfahren nach Anspruch 26 oder 27, bei dem im Isolationsgebiet vor dem Abscheiden des Basisschichtstapels eine an den inselförmigen Podestschicht lateral angrenzende Grube ausgebildet wird, die beim nachfolgendes Abscheiden des Basisschichtstapels verfüllt wird und Teil des Basisanschlussgebiets wird.

29. Verfahren zur Herstellung eines vertikalen Heterobipolartransistors, der die Merkmale eines der Ansprüche 22 bis 25 hat, mit den Schritten:
a) Bereitstellen eines hochohmigen einkristallinen Halbleitersubstrats (210) eines ersten Leitfähigkeitstyps mit einer vergrabenen Isolatorschicht (301),
b) Ausbilden einer Öffnung in der im Halbleitersubstrat vergrabenen Isolatorschicht (301),
c) Verfüllen der Öffnung mit einkristallinem Halbleitermaterial und Dotieren des Halbleitermaterials im Bereich der Öffnung zum Herstellen eines ersten und eines darüber liegenden zweiten Höhenabschnitts eines ersten Halbleiterelektrodengebiets (224) eines zweiten Leitungstyps (326),
d) Abscheiden eines Basisschichtstapels, der entweder insgesamt einkristallin ist oder einen sich in Höhenrichtung von der Oberseite der vergrabenen Isolatorschicht bis zur Oberseite des Basisschichtstapels erstreckenden, lateral begrenzten polykristallinen Lateralabschnitt hat,
e) Ausbilden eines Emitterfensters im Basisschichtstapel, dessen Öffnung sich über einen lateralen Abschnitt des Basisschichtstapels erstreckt, der kleiner ist als die Öffnung der Isolatorschicht,
f) Ausbilden einer Basis des ersten Leitfähigkeitstyps durch Dotieren des Basisschichtstapels in einem lateral durch die Öffnung des Emitterfensters begrenzten Bereich, und Ausbilden eines Basisanschlussgebiets durch Dotieren des Basisschichtstapels außerhalb des Emitterfensters
g) Ausbilden eines Emitters.

## Claims

1. Vertical heterobipolar transistor,
having a substrate (210; 300) of semiconductor material of a first conductivity type and an insulating region (212; 327) embodied therein,
- a first semiconductor electrode (220; 326) made of monocrystalline semiconductor material of a second conductivity type arranged in an opening in the insulating region (212; 327), said first electrode being embodied either as a collector or as an emitter and comprising a first vertical portion (220a) that is surrounded by the insulating region in lateral directions (I) located perpendicularly to a vertical direction (h) and comprising an adjacent second vertical portion (230a) further away from the inside of the substrate in the vertical direction (h), said vertical portion (230a) not being laterally surrounded by the insulating region,
- a second semiconductor electrode (260; 318) made of semiconductor material of the second conductivity type which is embodied as the other type of semiconductor electrode, i.e. as an emitter or, alternatively, as a collector, respectively,
- a base (230c; 314) made of monocrystalline semiconductor material of the first conductivity type between the collector and the emitter, and
- a base connecting region (233; 320) which comprises a monocrystalline portion (233a, 233b, 233c, 233d, 233e) which in the lateral direction laterally surrounds the second vertical portion (230a) of the first semiconductor electrode (220; 326) located further towards the interior of the substrate, viewed from the base, and which rests, with its underside facing towards the interior of the substrate, directly on the insulating region (212; 327), and which is hereinafter referred to as the Vertically Insulated Monocrystalline Base Connecting Region portion, VIMBCR for short,
**characterised in that** the lateral extent of a vertical portion (233a) of the VIMBCR portion (233a, 233b, 233c, 233d, 233e) which laterally surrounds the second vertical portion (230a) of the first semiconductor electrode (220) is greater than the distance, measured in the vertical direction, between an upper edge of the insulating region (212) and a lower edge of the base (230c).

2. Vertical bipolar transistor according to claim 1, wherein the vertical portion (233a) of the VIMBCR portion (233a, 233b, 233c, 233d, 233e) which laterally surrounds the second vertical portion (230a) of the first semiconductor electrode (220) rests on the insulating region (212; 327) over a lateral extent of at least 10 nm.

3. Vertical bipolar transistor according to claim 1, wherein the vertical portion (233a) of the VIMBCR portion (233a, 233b, 233c, 233d, 233e) which laterally surrounds the second vertical portion (230a) of the first semiconductor electrode (220) rests on the insulating region (212; 327) over a lateral extent of at least 30 nm.

4. Vertical bipolar transistor according to claim 1, wherein the vertical portion (233a) of the VIMBCR portion (233a, 233b, 233c, 233d, 233e) which laterally surrounds the second vertical portion (230a) of the first semiconductor electrode (220) rests on the insulating region (212; 327) over a lateral extent of at least 70 nm.

5. Vertical bipolar transistor according to one of the preceding claims, wherein the vertical portion (233a) of the VIMBCR portion (233a, 233b, 233c, 233d, 233e) which laterally surrounds the second vertical portion (230a) of the first semiconductor electrode (220) rests on the insulating region (212; 327) over the entire lateral extent of the base connecting region, and wherein the entire base connecting region is of monocrystalline configuration.

6. Vertical bipolar transistor according to claim 1, wherein the ratio between the lateral extent of the vertical portion (233a) of the VIMBCR portion (233a, 233b, 233c, 233d, 233e) which laterally surrounds the second vertical portion (230a) of the first semiconductor electrode (220) and the distance, measured in the vertical direction, between the upper edge of the insulating region (212) and the lower edge of the base (230c) is between more than 1 and 10.

7. Vertical bipolar transistor according to one of the preceding claims, wherein the vertical extent of the vertical portion (233a) of the VIMBCR portion (233a, 233b, 233c, 233d, 233e) which laterally surrounds the second vertical portion (230a) of the first semiconductor electrode (220) is between 5 nm and 100 nm.

8. Vertical bipolar transistor according to one of the preceding claims, wherein the vertical extent of the vertical portion (233a) of the VIMBCR portion (233a, 233b, 233c, 233d, 233e) which laterally surrounds the second vertical portion (230a) of the first semiconductor electrode (220) is between 20 nm and 50 nm.

9. Vertical bipolar transistor according to one of the preceding claims, wherein adjoining the VIMBCR portion (233a, 233b, 233c, 233d, 233e) on its side remote from the base is a polycrystalline lateral portion (231; 316) of the base connecting region.

10. Vertical bipolar transistor according to claim 1, wherein the VIMBCR portion adjoins the first semiconductor electrode in the lateral direction without one- or multi-dimensional dislocations or lattice defect adaptations to the first semiconductor electrode.

11. Vertical bipolar transistor according to one of the preceding claims, wherein the insulating region (212) is arranged in an opening of a field insulating region (211).

12. Vertical bipolar transistor according to one of the preceding claims, wherein the vertical extent of the insulating region is in the range from 10 nm to 250 nm.

13. Vertical bipolar transistor according to one of the preceding claims, wherein the insulating region comprises a trench which is filled with the material of the base connecting region.

14. Vertical bipolar transistor according to one of the preceding claims, wherein, viewed in cross-section, the first vertical portion of the first semiconductor electrode (220) tapers towards the second vertical portion (230a).

15. Vertical bipolar transistor according to claim 14, wherein, viewed in cross-section, the minimum lateral extent of the tapering first vertical portion (220) of the first semiconductor electrode is the same size as, or smaller than, the maximum lateral extent of the second semiconductor electrode (260).

16. Vertical bipolar transistor according to claim 15, wherein the first semiconductor electrode is embodied as an emitter and the second semiconductor electrode is embodied as a collector and the bipolar transistor is thus configured for a backwards operating mode.

17. Vertical bipolar transistor according to one of claims 1 to 15, wherein the first semiconductor electrode (220) is embodied as a collector and the second semiconductor electrode (260) is embodied as an emitter.

18. Vertical bipolar transistor according to one of the preceding claims, wherein a buffer layer (230b) of monocrystalline semiconductor material is provided between the second vertical portion (230a) of the first semiconductor electrode and the base (230c).

19. Vertical bipolar transistor according to one of the preceding claims, wherein a cover layer (230d) of monocrystalline semiconductor material is arranged between the base (230c) and the second semiconductor electrode (260).

20. Vertical bipolar transistor according to one of the preceding claims, wherein the second semiconductor electrode is T-shaped.

21. Vertical bipolar transistor according to one of the preceding claims, wherein the first semiconductor electrode contains, in the first vertical portion (220a) or in the second vertical portion (230a), a plurality of layers with different material compositions or a plurality of layer portions with different levels of dopant concentration.

22. Vertical bipolar transistor according to one of the preceding claims, wherein the substrate is an SOI substrate.

23. Vertical bipolar transistor according to claim 22, wherein a silicon covering layer of the SOI substrate has a thickness of less than 50 nm.

24. Vertical bipolar transistor according to claim 22 or 23, wherein a lateral portion (316) of the base connecting region comprising one- or multi-dimensional dislocations or lattice defect adaptations is laterally bounded by the VIMBCR portion and, on its side (316) remote from the base, it adjoins a second monocrystalline portion of the base connecting region.

25. Vertical bipolar transistor according to claim 23 or 24, wherein the polycrystalline lateral portion (316) of the base connecting region has a lateral extent of at most 80 nm.

26. Method of producing a vertical heterobipolar transistor which has the features of one of claims 1 to 21, comprising the steps of:
a) preparing a high-resistance monocrystalline semiconductor substrate (210) of a first conductivity type with a first vertical portion of a first semiconductor electrode region (224) of a second conductivity type,
b) producing a monocrystalline insular pedestal layer (225) over the first vertical portion of the first semiconductor electrode region (224),
c) forming a trench about the insular pedestal layer (225) such that the pedestal layer (225) finally resists on a support region (220) of the first vertical portion of the first semiconductor electrode region and projects laterally beyond the support region,
d) filling the trench with insulating material to produce an insulating region (212),
e) differential epitaxial precipitation of a stack of layers over the insular pedestal layer with a monocrystalline base layer,
f) forming a base region and a base connecting region by doping the stack of layers and forming a second vertical portion of the first semiconductor electrode, which is restricted in the lateral direction to the lateral extent of the support region,
so that the base connecting region (233; 320) comprises a monocrystalline portion (233a, 233b, 233c, 233d, 233e) which in the lateral direction laterally surrounds the base and the second vertical portion (230a) of the first semiconductor electrode (220; 326) located further towards the interior of the substrate, viewed from the base, and which rests, with its underside facing the interior of the substrate, directly on the insulating region (211; 327), and which is hereinafter referred to as the Vertically Insulated Monocrystalline Base Connecting Region portion, VIMBCR for short, and
g) forming a second semiconductor electrode of the second conductivity type.

27. Method according to claim 26, wherein the step of preparing a high-resistance monocrystalline semiconductor substrate (210) of a first conductivity type with a first vertical portion of a first semiconductor electrode region (224) of a second conductivity type comprises the following subsidiary steps:
a1) forming at least one field insulating region (211) with an opening (200) that contains monocrystalline semiconductor material (224),
a2) conductivity doping to form semiconductor material (224) of a second conductivity type for a first semiconductor electrode in the opening (200).

28. Method according to claim 26 or 27, wherein, before the deposition of the base layer stack, a trench is formed in the insulating region laterally adjacent to the insular pedestal layer, this trench being filled during the subsequent deposition of the base layer stack and becoming part of the base connecting region.

29. Method of producing a vertical heterobipolar transistor which has the features of one of claims 22 to 25, comprising the steps of:
a) preparing a high-resistance monocrystalline semiconductor substrate (210) of a first conductivity type with a buried insulating layer (301),
b) producing an opening in the insulating layer (301) buried in the semiconductor substrate,
c) filling the opening with monocrystalline semiconductor material and doping the semiconductor material in the region of the opening in order to form a first and, above it, a second vertical portion of a first semiconductor electrode region (224) of a second conductivity type (326),
d) depositing a base layer stack which is either entirely monocrystalline or has a laterally bounded polycrystalline lateral portion extending in the vertical direction from the top of the buried insulating layer to the top of the base layer stack,
e) forming an emitter window in the base layer stack, the opening of which extends over a lateral portion of the base layer stack which is smaller than the opening in the insulating layer,
f) forming a base of the first conductivity type by doping the base layer stack in a region that is laterally bounded by the opening of the emitter window, and forming a base connecting region by doping the base layer stack outside the emitter window,
g) forming an emitter.

## Revendications

1. Transistor bipolaire vertical à hétérojonction,
muni d'un substrat (210 ; 300) en un matériau semi-conducteur d'un premier type de conductivité et d'une zone d'isolation (212 ; 327) formée à l'intérieur dudit substrat,
- d'une première électrode semi-conductrice (220 ; 326) en un matériau semi-conducteur monocristallin d'un deuxième type de conductivité, qui est disposée dans une ouverture de la zone d'isolation (212 ; 327), est conçue en forme soit de collecteur, soit d'émetteur et comporte une première section en hauteur (220a) qui est entourée par la zone d'isolation dans des directions latérales (1) s'étendant perpendiculairement à une direction verticale (h) et comporte une deuxième section en hauteur (230a) adjacente, plus éloignée dans la direction verticale (h) de l'intérieur du substrat, qui n'est pas entourée latéralement par la zone d'isolation,
- d'une deuxième électrode semi-conductrice (260 ; 318) en un matériau semi-conducteur du deuxième type de conductivité, qui est conçue sous forme de l'autre type d'électrode semi-conductrice, c'est-à-dire en tant qu'émetteur ou en variante en tant que collecteur,
- d'une base (230c; 314) en un matériau semi-conducteur monocristallin du premier type de conductivité entre le collecteur et l'émetteur, et
- d'une zone de connexion de base (233; 320) comportant une section monocristalline (233a, 233b, 233c, 233d, 233e) laquelle entoure dans une direction latérale la deuxième section en hauteur (230a) de la première électrode semi-conductrice (220; 326), vu de la base, plus éloignée de l'intérieur du substrat, laquelle repose par sa face inférieure tournée vers l'intérieur du substrat directement sur la zone d'isolation (212; 327) et laquelle est appelée ci-après section de connexion de base verticale isolée monocristalline, en abrégé section VIEBAG,
**caractérisé en ce que** l'étendue latérale d'une section en hauteur (233a) de la section VIEBAG (233a, 233b, 233c, 233d, 233e), laquelle entoure latéralement la deuxième section en hauteur (230a) de la première électrode semi-conductrice (220), est plus grande que la distance, mesurée dans la direction verticale, entre une arête supérieure de la zone d'isolation (212) et une arête inférieure de la base (230c).

2. Transistor bipolaire vertical selon la revendication 1, dans lequel la section en hauteur (233a) de la section VIEBAG (233a, 233b, 233c, 233d, 233e), laquelle entoure latéralement la deuxième section en hauteur (230a) de la première électrode semi-conductrice (220), repose sur la zone d'isolation (212 ; 327) sur une étendue latérale d'au moins 10 nm.

3. Transistor bipolaire vertical selon la revendication 1, dans lequel la section en hauteur (233a) de la section VIEBAG (233a, 233b, 233c, 233d, 233e), laquelle entoure latéralement la deuxième section en hauteur (230a) de la première électrode semi-conductrice (220), repose sur la zone d'isolation (212 ; 327) sur une étendue latérale d'au moins 30 nm.

4. Transistor bipolaire vertical selon la revendication 1, dans lequel la section en hauteur (233a) de la section VIEBAG (233a, 233b, 233c, 233d, 233e), laquelle entoure latéralement la deuxième section en hauteur (230a) de la première électrode semi-conductrice (220), repose sur la zone d'isolation (212 ; 327) sur une étendue latérale d'au moins 70 nm.

5. Transistor bipolaire vertical selon l'une quelconque des revendications précédentes, dans lequel la section en hauteur (233a) de la section VIEBAG (233a, 233b, 233c, 233d, 233e), laquelle entoure latéralement la deuxième section en hauteur (230a) de la première électrode semi-conductrice (220), repose sur la zone d'isolation (212; 327) sur toute l'étendue latérale de la zone de connexion de base, et dans lequel la zone de connexion de base est formée intégralement d'un matériau monocristallin.

6. Transistor bipolaire vertical selon la revendication 1, dans lequel le rapport entre l'étendue latérale de la section en hauteur (233a) de la section VIEBAG (233a, 233b, 233c, 233d, 233e), laquelle entoure latéralement la deuxième section en hauteur (230a) de la première électrode semi-conductrice (220), et la distance, mesurée dans la direction verticale, entre l'arête supérieure de la zone d'isolation (212) et l'arête inférieure de la base (230c) est situé entre plus de 1 et 10.

7. Transistor bipolaire vertical selon l'une quelconque des revendications précédentes, dans lequel l'étendue verticale de la section en hauteur (233a) de la section VIEBAG (233a, 233b, 233c, 233d, 233e), laquelle entoure latéralement la deuxième section en hauteur (230a) de la première électrode semi-conductrice, (220) est située entre 5 nm et 100 nm.

8. Transistor bipolaire vertical selon l'une quelconque des revendications précédentes, dans lequel l'étendue verticale de la section en hauteur (233a) de la section VIEBAG (233a, 233b, 233c, 233d, 233e), laquelle entoure latéralement la deuxième section en hauteur (230a) de la première électrode semi-conductrice (220), est située entre 20 nm et 50 nm.

9. Transistor bipolaire vertical selon l'une quelconque des revendications précédentes, dans lequel une section latérale polycristalline (231 ; 316) de la zone de connexion de base est limitrophe à la section VIEBAG (233a, 233b, 233c, 233d, 233e) sur son côté opposé à la base.

10. Transistor bipolaire vertical selon la revendication 1, dans lequel la section VIEBAG est contigüe à la première électrode semi-conductrice dans une direction latérale sans décalages monodimensionnels ou multidimensionnels ou désadaptations de grille.

11. Transistor bipolaire vertical selon l'une quelconque des revendications précédentes, dans lequel la zone d'isolation (212) est disposée dans une ouverture d'une zone d'isolation de champ (211).

12. Transistor bipolaire vertical selon l'une quelconque des revendications précédentes, dans lequel l'étendue verticale de la zone d'isolation est située dans une plage de 10 nm à 250 nm.

13. Transistor bipolaire vertical selon l'une quelconque des revendications précédentes, dans lequel la zone d'isolation comporte une fosse qui est remplie avec le matériau de la zone de connexion de base.

14. Transistor bipolaire vertical selon l'une quelconque des revendications précédentes, dans lequel, vue en coupe transversale, la première section en hauteur de la première électrode semi-conductrice (220) se rétrécit en direction de la deuxième section en hauteur (230a).

15. Transistor bipolaire vertical selon la revendication 14, dans lequel, vue en coupe transversale, l'étendue latérale minimale de la première section en hauteur (220) se rétrécissant de la première électrode semi-conductrice est inférieure ou égale à l'étendue latérale maximale de la deuxième électrode semi-conductrice (260).

16. Transistor bipolaire vertical selon la revendication 15, dans lequel la première électrode semi-conductrice est conçue sous forme d'émetteur et la deuxième électrode semi-conductrice sous forme de collecteur et le transistor bipolaire est ainsi conçu pour un mode opératoire inverse.

17. Transistor bipolaire vertical selon l'une quelconque des revendications 1 à 15, dans lequel la première électrode semi-conductrice (220) est conçue sous forme de collecteur et la deuxième électrode semi-conductrice (260) sous forme d'émetteur.

18. Transistor bipolaire vertical selon l'une quelconque des revendications précédentes, dans lequel une couche tampon (230b) en un matériau semi-conducteur monocristallin est disposée entre la deuxième section en hauteur (230a) de la première électrode semi-conductrice et la base (230c).

19. Transistor bipolaire vertical selon l'une quelconque des revendications précédentes, dans lequel une couche de recouvrement (230d) en un matériau semi-conducteur monocristallin est disposée entre la base (230c) et la deuxième électrode semi-conductrice (260).

20. Transistor bipolaire vertical selon l'une quelconque des revendications précédentes, dans lequel la deuxième électrode semi-conductrice a une forme de T.

21. Transistor bipolaire vertical selon l'une quelconque des revendications précédentes, dans lequel la première électrode semi-conductrice dans la première section en hauteur (220a) ou dans la deuxième section en hauteur (230a) contient une pluralité de couches présentant différentes compositions matérielles ou une pluralité de sections de couches présentant des concentrations de dopage différemment élevées.

22. Transistor bipolaire vertical selon l'une quelconque des revendications précédentes, dans lequel le substrat est un substrat SOI (silicium sur isolant).

23. Transistor bipolaire vertical selon la revendication 22, dans lequel une couche de couverture en silicium du substrat SOI a une épaisseur inférieure à 50 nm.

24. Transistor bipolaire vertical selon la revendication 22 ou 23, dans lequel une section latérale (316), présentant des décalages monodimensionnels ou pluridimensionnels ou des désadaptations de grille, de la zone de connexion de base est limitée latéralement par la section VIEBAG et est contigüe sur son côté (316) opposé à la base à une deuxième section monocristalline de la zone de connexion de base.

25. Transistor bipolaire vertical selon la revendication 23 ou 24, dans lequel la section latérale polycristalline (316) de la zone de connexion de base a une étendue latérale au maximum de 80 nm.

26. Procédé de fabrication d'un transistor bipolaire vertical à hétérojonction, qui présente les caractéristiques d'une des revendications 1 à 21, comprenant les étapes consistant à :
a) préparer un substrat semi-conducteur monocristallin de valeur ohmique élevée (210) d'un premier type de conductivité ayant une première section en hauteur d'une première zone d'électrode semi-conductrice (224) d'un deuxième type de conductivité,
b) produire une couche socle monocristalline en forme d'îlot (225) sur la première section en hauteur de la première zone d'électrode semi-conductrice (224),
c) former un fossé autour de la couche socle en forme d'îlot (225) de sorte que la couche socle (225) repose fmalement sur une zone socle (220) de la première section en hauteur de la première zone d'électrode semi-conductrice et fasse saillie latéralement au-dessus de la zone socle,
d) remplir le fossé avec un matériau isolant afin de créer une zone d'isolation (212),
e) séparer par épitaxie différentielle une pile de couches sur la couche socle en forme d'îlot avec une couche de base monocristalline,
f) former une zone de base et une zone de connexion de base par dopage de la pile de couches ainsi que former une deuxième section en hauteur de la première électrode semi-conductrice limitée dans une direction latérale à l'étendue latérale de la zone socle,
de manière teile que la zone de connexion de base (233 ; 320) comporte une section monocristalline (233a, 233b, 233c, 233d, 233e) qui entoure dans la direction latérale la base et la deuxième section en hauteur (230a), située vu de la base plus à l'intérieur du substrat, de la première électrode semi-conductrice (220 ; 326), et qui repose avec sa face inférieure tournée vers l'intérieur du substrat directement sur la zone d'isolation (211 ; 327), et qui est appelée ci-après section de zone de connexion de base monocristalline isolée verticale, en abrégé section VIEBAG, et
g) former une deuxième électrode semi-conductrice du deuxième type de conductivité.

27. Procédé selon la revendication 26, dans lequel l'étape de préparation d'un substrat semi-conducteur monocristallin de valeur ohmique élevée (210) d'un premier type de conductivité présentant une première section en hauteur d'une première zone d'électrode semi-conductrice (224) d'un deuxième type de conductivité comporte les sous-étapes suivantes consistant à :
al) former au moins une zone d'isolation de champ (211) ayant une ouverture (200) qui contient le matériau semi-conducteur monocristallin (224),
a2) doper la conductivité afm de former un matériau semi-conducteur (224) d'un deuxième type de conductivité pour une première électrode semi-conductrice dans l'ouverture (200).

28. Procédé selon la revendication 26 ou 27, selon lequel, une fosse contigüe latéralement à la couche socle en forme d'îlot est formée dans la zone d'isolation avant la séparation de la pile de couches de base, ladite fosse étant remplie lors de la séparation subséquente de la pile de couches de base et formant une partie de la zone de connexion de base.

29. Procédé de fabrication d'un transistor bipolaire vertical à hétérojonction, qui présente les caractéristiques d'une des revendications 22 à 25, comportant les étapes consistant à :
a) préparer un substrat semi-conducteur monocristallin de valeur ohmique élevée (210) d'un premier type de conductivité ayant une couche d'isolateur enfouie (301),
b) former une ouverture dans la couche d'isolateur (301) enfouie dans le substrat semi-conducteur,
c) remplir l'ouverture avec un matériau semi-conducteur monocristallin et doper le matériau semi-conducteur dans la zone de l'ouverture afin de créer une première section en hauteur et une deuxième section en hauteur, reposant sur ladite première section, d'une première zone d'électrode semi-conductrice (224) d'un deuxième type de conductivité (326),
d) séparer une pile de couches de base qui soit est intégralement monocristalline, soit a une section latérale polycristalline limitée latéralement, s'étendant dans la direction verticale de la face supérieure de la couche d'isolateur enfouie jusqu'à la face supérieure de la pile de couches de base,
e) former dans la pile de couches de base une fenêtre d'émetteur dont l'ouverture s'étend sur une section latérale de la pile de couches de base et qui est plus petite que l'ouverture de la couche d'isolation,
f) former une base du premier type de conductivité par dopage de la pile de couches de base dans une zone limitée latéralement par l'ouverture de la fenêtre d'émetteur, et former une zone de connexion de base par dopage de la pile de couches de base à l'extérieur de la fenêtre d'émetteur
g) former un émetteur.
